Europäisches Patentamt

European Patent Office

Office européen des brevets

(19)

(11) EP 0 309 292 B1

(12) **EUROPEAN PATENT SPECIFICATION**

(45) Date of publication and mention
of the grant of the patent:
**09.04.1997 Bulletin 1997/15**

(51) Int Cl.$^6$: **G06F 17/50**

(21) Application number: **88308899.9**

(22) Date of filing: **26.09.1988**

(54) **Circuit transformation system, circuit transformation method, inverted logic generation method, and logic design system**

Schaltungsveränderungssystem und -verfahren, Verfahren zur Erzeugung von invertierter Logik und Logikentwurfssystem

Système et méthode de transformation de circuit, méthode de génération de logique inversée et système de conception de logique

(84) Designated Contracting States:
**DE FR GB**

(30) Priority: **25.09.1987 JP 241288/87**
**22.01.1988 JP 12941/88**
**15.03.1988 JP 61082/88**

(43) Date of publication of application:
**29.03.1989 Bulletin 1989/13**

(73) Proprietor: **MATSUSHITA ELECTRIC INDUSTRIAL CO., LTD.**
**Kadoma-shi, Osaka-fu, 571 (JP)**

(72) Inventors:
• **Nishiyama, Tamotsu**
**Hirakata Osaka (JP)**
• **Matsumoto, Noriko**
**Uji Kyoto (JP)**
• **Ueda, Masahiko**
**Kashiwara Osaka (JP)**
• **Matsunaka, Masahiko**
**Nishiyodogawa-ku Osaka Osaka 555 (JP)**

(74) Representative: **Crawford, Andrew Birkby et al**
**A.A. THORNTON & CO.**
**Northumberland House**
**303-306 High Holborn**
**London WC1V 7LE (GB)**

(56) References cited:
**EP-A- 0 217 291**

• **23RD ACM/IEEE DESIGN AUTOMATION CONFERENCE, 29th June-2nd July 1986, pages 594-600, IEEE, New York, US; T. SAITO et al.: "A rule-based logic circuit synthesis system for CMOS gate arrays"**
• **24TH ACM/IEEE DESIGN AUTOMATION CONFERENCE, Miami Beach, Fla., 28th June-1st July 1987, pages 523-529, IEEE, New York, US; S. SUZUKI et al.: "Trip: an automated technology mapping system"**
• **IEEE DESIGN & TEST OF COMPUTERS, vol. 1, no. 1, February 1984, pages 60-69, IEEE, New York, US; T.J. KOWALSKI et al.: "The VLSI design automation assistant: an IBM system/370 design"**

**Description**

Background of the Invention

This invention relates to automatic transformation of logic circuit, and more particularly to a circuit transformation method or logic design system suited to optimally transformating function description or logic circuit equivalently logically into a circuit for a specific technology.

A conventional circuit automatic transformation system is a method for detecting a portion coinciding with a predefined input pattern from a circuit before transformation, and replacing directly with a corresponding output pattern according to the condition such as the fan-out number of the output terminal (mentioned, for example, in the Collected Papers of the 30th National Convention of Information Processing Society of Japan, pp. 1923-1926, 1985), and in a system using knowledge base (that is, rule base), the rule description system of describing the preliminary condition for starting up the rule in the condition part of the rule, and describing the operation (that is, the action) on the circuit when that rule is started up in the conclusion part is widely employed. An apparatus of this sort is disclosed, for example, in the Japanese Laid-open Patent No. 59-168545.

In this conventional example, however, considerations are not given to the simplification of circuit transformation rule, efficiency of transformation rule making, its ease, and efficiency of circuit transormation processing, and the following problems, among others, existed.

(1) It is necessary to make many transformation rules differing only in part, such as the condition part and conclusion part of transformation rule.

(2) Different from the transformation rule possessed by the designer, it is necessary to describe, in an unnatural form, how to change the circuit, being conscious of the deduction mechanism, when describing the conclusion part of the rule.

(3) In order to realize an advanced transformation from a comprehensive viewpoint conducted by a skilled designer, the description quantity per rule is enormous, and the number of rules is tremendous, which is actually difficult to realize.

(4) From the viewpoint of transformation processing efficiency, there are many transformation rules similar in the condition part, the inference efficiency is very poor, and a lengthy processing time is needed for transformation.

(5) When divising and describing transformation rule in plural rules, wasteful accesses addition of intermediate data to the description part for working (working memory), retrieval and deletion increase, and the efficiency of inference processing is extremely poor.

EP-A-0217291 discloses an example of means for transforming an original circuit, via two intermediate circuits stages, into a target circuit using three transformation rule basis. This may be used for example for tranforming a CMOS circuit into IIL circuit. In this disclosure the first transforming stage transformed the original circuit into a first intermediate circuit comprising parts which are easy to convert into the target circuit system. In the second transformation the first intermediate circuit is transformed into a second circuit by utilizing a basic transformations for the circuit alteration which is being performed. In the third transformation the second intermediate circuit is optimized for such consideration as fan-out and to remove redundant circuits.

The present invention provides a method of transforming a first circuit constituted by a first set of elements into a logically equivalent second circuit constituted by a second set of elements, comprising

selecting a candidate rule from a knowledge base memory storing transformation rules comprising general rules and local rules, each rule being expressed by a formula with a condition part and a conclusion part;

expanding the condition part of said candidate rule by replacing a portion of said condition part which matches the condition part of a local rule by the conclusion part of the local rule;

matching the expanded condition part of said candidate rule to circuit data stored in a working memory;

judging the applicability of said candidate rule;

removing the elements of the condition part of said candidate rule from said circuit data in said working memory;

expanding the conclusion part of said candidate rule by replacing a portion of said conclusion part which matches the condition part of a local rule by the conclusion part of the local rule; and

applying said candidate rule, in which the condition part and conclusion part have been expanded, to the circuit data in said working memory, after confirming the applicability of said candidate rule.

The present invention also provides a logic design system for transforming a first circuit constituted by a first set of elements into a logically equivalent second circuit constituted by a second set of elements, comprising

knowledge base memory means for storing circuit transformation rules, comprising general rules and local rules, each of the transformation rules being expressed by a formula with a condition part and a conclusion part;
input means for entering a functional description and for translating said functional description into circuit data;
working memory means for storing said circuit data;
output means for delivering circuit data from said working memory;
inference means for inferring the second set of elements on the basis of said transformation rules;
program execution means for storing and executing programs to control operations of the system, including judgements, operations and functions according to said transformation rules,
and said inference means comprising,
rule selection means and local rule selection means for selecting a candidate rule from the transformation rules;
rule holding means for holding said candidate rule;
rule replacing means for expanding the condition part and the conclusion part of said candidate rule by replacing a portion of the respective part which matches the condition part of a local rule by the conclusion part of the local rule;
element search means for searching for elements in the circuit data stored in said working memory;
rule matching means for comparing the expanded condition part of said candidate rule with the circuit data in said working memory, using said element search means and said program execution means, and for checking the applicability of said candidate rule;
element storing means for extracting elements to be removed according to elements described in said candidate rule, and for storing said extracted elements;
element removal means for sequentially removing the elements extracted and stored in said element storing means, from the circuit data stored in said working memory, after the applicability of said candidate rule is established by said rule matching means;
rule applying means for updating the data in said working memory through additionally registering the elements described in said expanded conclusion part by said program execution means, after confirming said applicability; and
element addition means for additionally registering the element which is extracted from elements described in the expanded conclusion part of said candidate rule, into the data stored in said working memory; and
rule requisition means for causing said local rule selection means to select a new transformation rule to be applied and to transmit it to said rule holding means, as necessary according to the conclusion part of said candidate rule which was last applied by said rule applying means

The present invention further provides a method of transforming a first circuit constituted by a first set of elements into a logically equivalent circuit constituted by a second set of elements, comprising:

selecting a candidate rule from a knowledge base memory storing transformation rules, each rule being expressed by a formula with a condition part and a conclusion part;
matching a candidate rule to circuit data stored in a working memory;
checking the applicability of said candidate rule;
applying said candidate rule to the circuit data for transforming the circuit after confirming the applicability of the candidate rule, wherein this step of applying said candidate rule comprises the steps of,
judging whether each signal of output/input signals of an element expresses a logic negation of a specific signal and extracting said signal when the element is being additionally registered through transforming into the circuit data stored in said working memory;
updating the circuit data and extracting said signal from the circuit data according to a logic negation rule selected from a logic negation knowledge base memory storing logic negation rules which relate a logic circuit to another logic circuit with at least one of plural negated output/input signals, if the logic negation is judged to be applicable, said signal being equivalent to the logic negation of said specific signal; and
generating said signal by adding an inverter which accepts said specific signal, to the circuit data, if the logic negation rule is judged to be inapplicable.

This invention also provides a logic design system for transforming a first circuit constituted by a first set of elements into a logically equivalent second circuit constituted by a second set of elements, comprising;

a knowledge base memory means for storing circuit transformation rules, each of the transformation rules being expressed by a formula with a condition part and a conclusion part;

input means for entering a functional description and for translating said functional description into circuit data;

working memory means for storing said circuit data;

output means for delivering circuit data from said working memory;

inference means for inferring the second set of elements on the basis of said transformation rules;

program execution means for storing and executing programs of processing operations including judgements, operations and functions according to said transformation rules, and

logic negation knowledge base memory for storing logic negation rules which relate a logic circuit to another logic circuit with at least one of plural negated output/input signals,

and said inference means comprising,

rule selection means for selecting a candidate rule from the transformation rules;

rule holding means for holding said candidate rule;

element search means for searching for elements in the circuit data stored in said working memory;

rule matching means for comparing the condition part of said candidate rule with the circuit data in said working memory, using said element search means and said program execution means, and for checking the application of said candidate rule;

element storing means for extracting elements to be removed according to elements described in said candidate rule, and for storing said extracted elements;

element removal means for sequentially removing the elements extracted and stored in said element storing means, from the circuit data stored in said working memory after the applicability of said candidate rule is established by said rule matching means;

rule applying means for updating the data in said working memory through additionally registering elements described in said conclusion part by element addition means and said program execution means, after confirming said applicability; and

element addition means for additionally registering the element which is extracted from elements described in the conclusion part of said candidate rule, into the data stored in said working memory; and

logic negation signal generating means for generating the logic negation signal of a specific signal from the data to be stored in said working memory by making use of said logic negation rules.

The present invention yet further provides a method of transforming a first circuit constituted by a first set of elements into a logically equivalent second circuit constituted by a second set of elements, comprising

selecting a candidate rule from a knowledge base memory storing transformation rules, each rule being expressed by a formula with a condition part and a conclusion part;

matching said candidate rule to circuit data stored in a working memory;

judging the applicability of said candidate rule; and

applying said candidate rule to the circuit data for transforming the circuit, after confirming the applicability of the candidate rule;

recognizing a subcircuit of the circuit data as a circuit logically equivalent to a circuit described in the condition part in said candidate rule, when said applicability is not confirmed, by using a logic equivalence rule which is stored in a logic equivalence knowledge base memory.

The present invention additionally provides a logic design system for transforming a first circuit constituted by a first set of elements into a logically equivalent second circuit constituted by a second set of elements, comprising

a knowledge base memory means (1) for storing circuit transformation rules (13), each of the transformation rules being expressed by a formula with a condition part and a conclusion part;

input means (2) for entering a functional description and for translating said functional description into circuit data,

working memory means (3) for storing said circuit data;

output means (4) for delivering circuit data from said working memory (3);

inference means (5) for inferring the second set of elements on the basis of said transformation rules;

program execution means (6) for storing and executing programs of processing operations including judgements, operations and functions according to said transformation rules (13),

logic equivalence knowledge base memory (8) for storing logic equivalence rules (40) which express that a circuit is logically equivalent to another circuit; and

said inference means (5) comprising,

rule selection means (14) for selecting a candidate rule, the candidate rule being one of the transformation rules (13);

rule holding means (22) for holding said candidate rule;

element search means (25) for searching for an element in circuit data stored in said working memory (3);
circuit recognition means (8,25) for recognizing a subcircuit of data as a circuit logically equivalent to a portion of condition part of said candidate rule and one of said equivalence rule (40) stored in said equivalent knowledge base memory (8);
rule matching means (24) for comparing the condition part of said candidate rule with the circuit data in said working memory (3), using said element search means (25), said program execution means (6) and circuit recognition means, and for checking the applicability of said candidate rule.

It is hence a primary advantage of this invention that a circuit transformation method, circuit transformation system, and logic design system are presented capable of taking in the circuit transformation knowledge possessed by the designer easily in a simple form of transformation rule, and realizing circuit transformation easily as proficiently as a skilled designer.

While the novel features of the invention are set forth in the appended claims, the invention, both as to organization and content, will be better understood and appreciated, along with other objects and features thereof, from the following detailed description taken in conjunction with the drawings.

Brief Description of Drawings

Fig. 1 is a block diagram showing a basic structure in a first embodiment of this invention;

Fig. 2 is a conceptual drawing of hierarchical structuring of rule;

Fig. 3 is a explanatory drawing showing an example of transformation rule;

Fig. 4 is an explanatory drawing showing an example of circuit expression;

Fig. 5 is a flow chart showing an example of circuit transformation processing in the inference means of the embodiment;

Fig. 6 is a flow chart showing an example of matching processing of rule condition part;

Fig. 7 is a flow chart showing an example of application processing of rule conclusion part;

Fig. 8 is an explanatory drawing showing a description example of transformation rule;

Fig. 9 is an explanatory drawing showing a description example of expanding rule;

Fig. 10 is a block diagram showing a basic structure in a second embodiment of this invention;

Fig. 11 is an explanatroy drawing showing an example of logic negation rule;

Fig. 12 is a flow chart showing an example of circuit transformation processing in the inference means of the embodiment;

Fig. 13 is a flow chart showing an example of processing into the working memory addition;

Fig. 14 is a flow chart showing an example of logic negation signal generation processing;

Fig. 15 is an explanatory chart showing a description example of tranformation rule;

Fig. 16 is an explanatory drawing showing a description example of logic negation rule;

Fig. 17 is an explanatory drawing showing a description example of transformation rule suing logic negation signal;

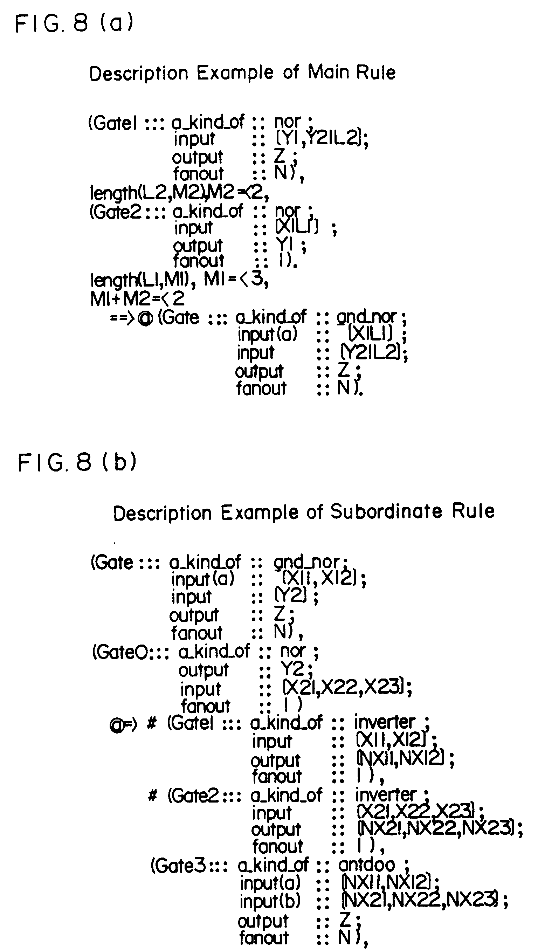

Fig. 8 is a block diagram showing a basic structure in a third embodiment of this invention;

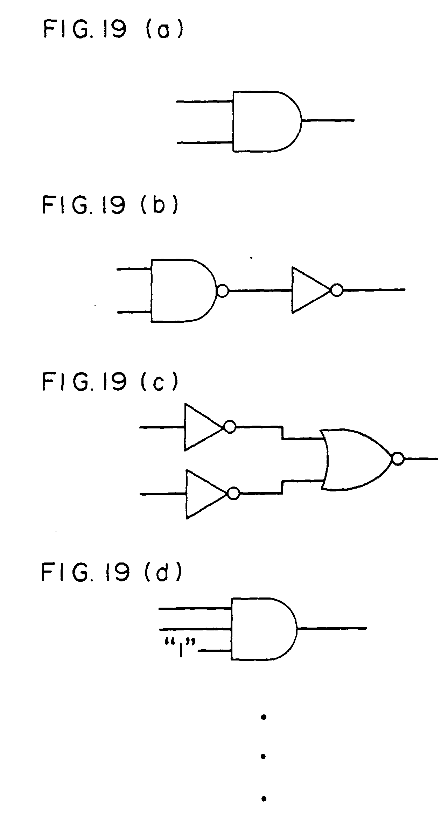

Fig. 19 is a circuit diagram showing a circuit equivalent to two input ANDs;

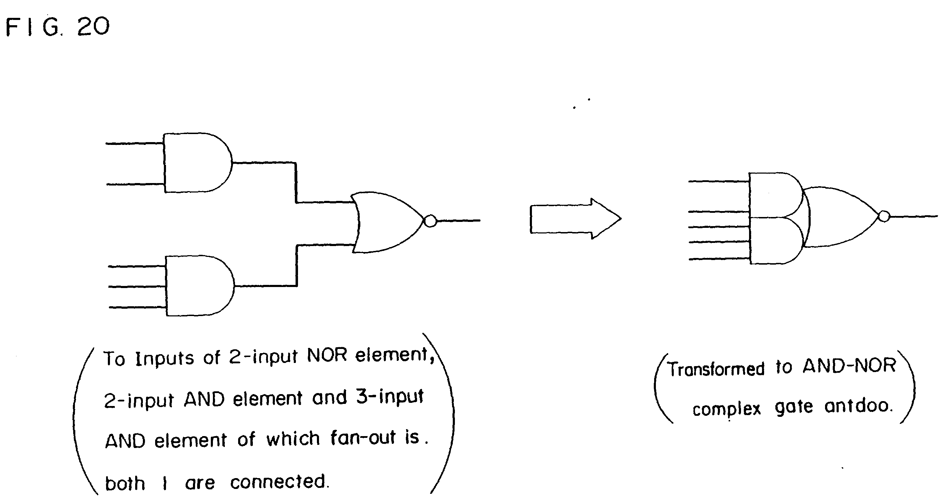

Fig. 20 is an explanatory drawing showing an example of transformation rule;

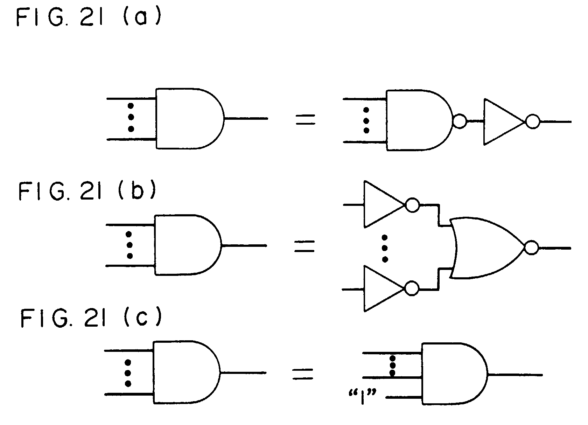

Fig. 21 is an explanatory drawing showing an example of logic equivalence rule;

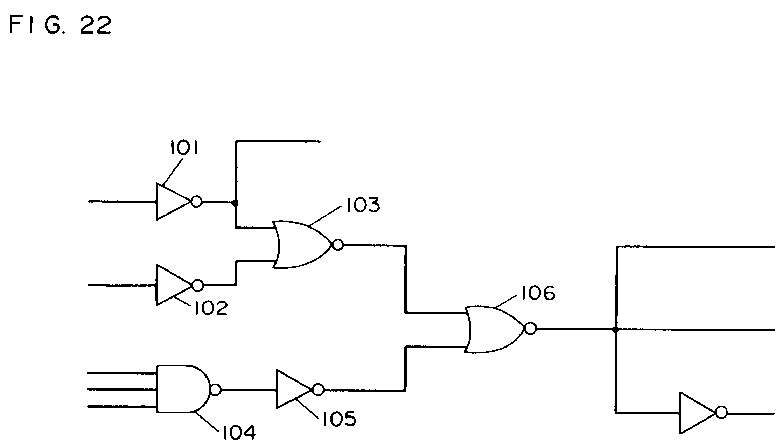

Fig. 22 is a partial circuit diagram as an example of a transformation object circuit;

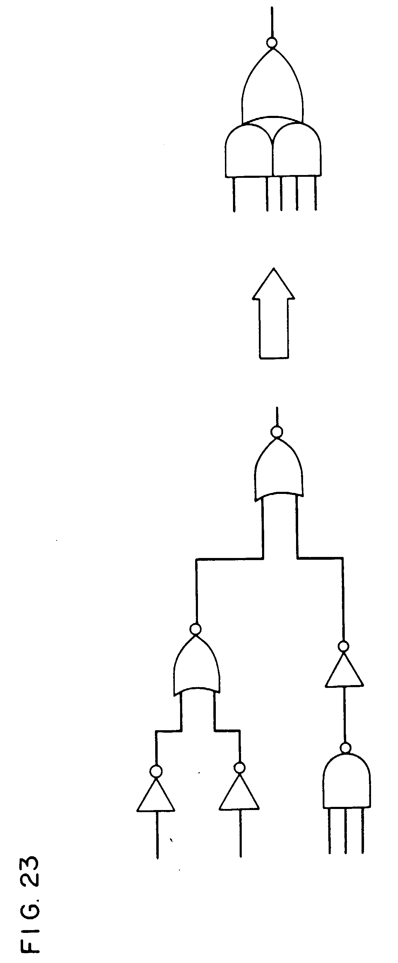

Fig. 23 is an explanatory drawing showing a transformation rule logically equivalent to the transformation rule in Fig. 20;

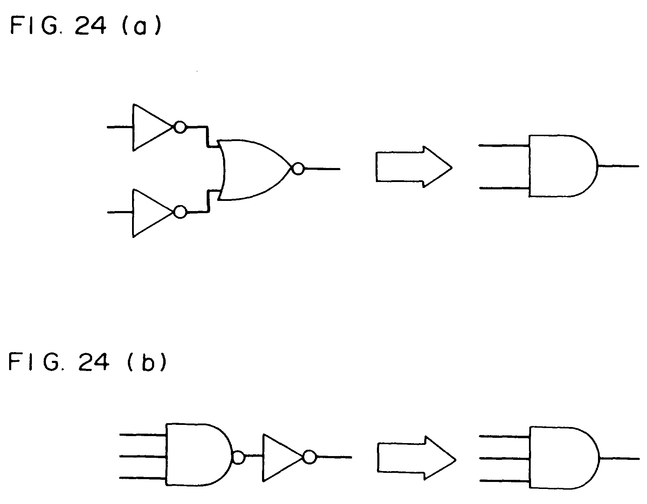

Fig. 24 is an explanatory drawing showing a tranformation rule for transformation into AND circuit; and

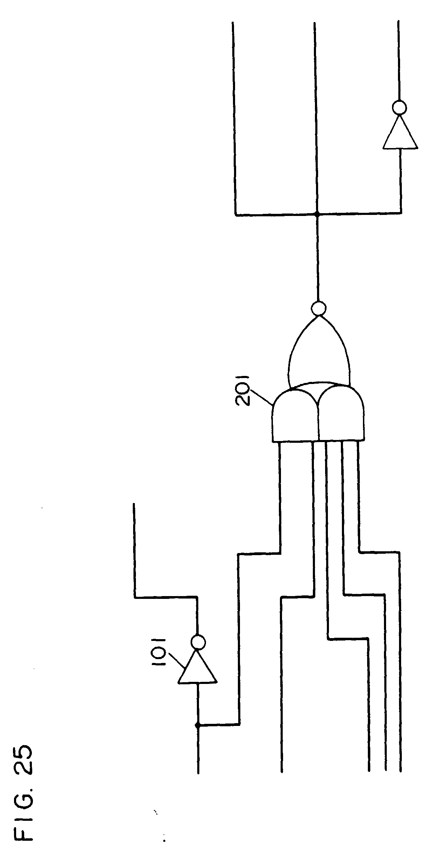

Fig. 25 is a circuit diagram after transformation of Fig. 22.

Detailed Description of the Invention

Some of the embodiments of this invention are described below while referring to the accompanying drawings.

First embodiment

Referring now to the drawings, a first embodiment of this invention is described below.

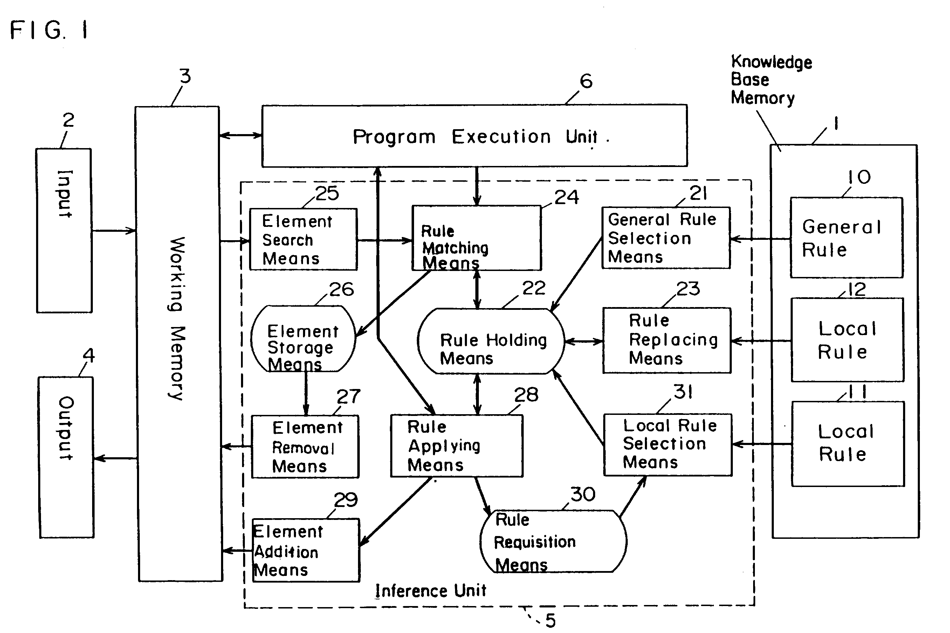

Fig. 1 is a block diagram showing a basic structure of the first embodiment of this invention, in which numeral 1 denotes a knowledge base memory, 2 is an input means, 3 is a working memory, 4 is an output means, 5 is a inference means (interpreter), and 6 is a program execution means for storing the program and executing it as required. The inference means 5 is composed of general rule selection means 21, rule holding means 22, rule replacing means 23, rule matching means 24, element search means 25, element storing means 26, element removal means 27, rule applying means 28, element addition means 29, rule requisition means 30, and local rule selection means 31.

Each part is explained in details below.

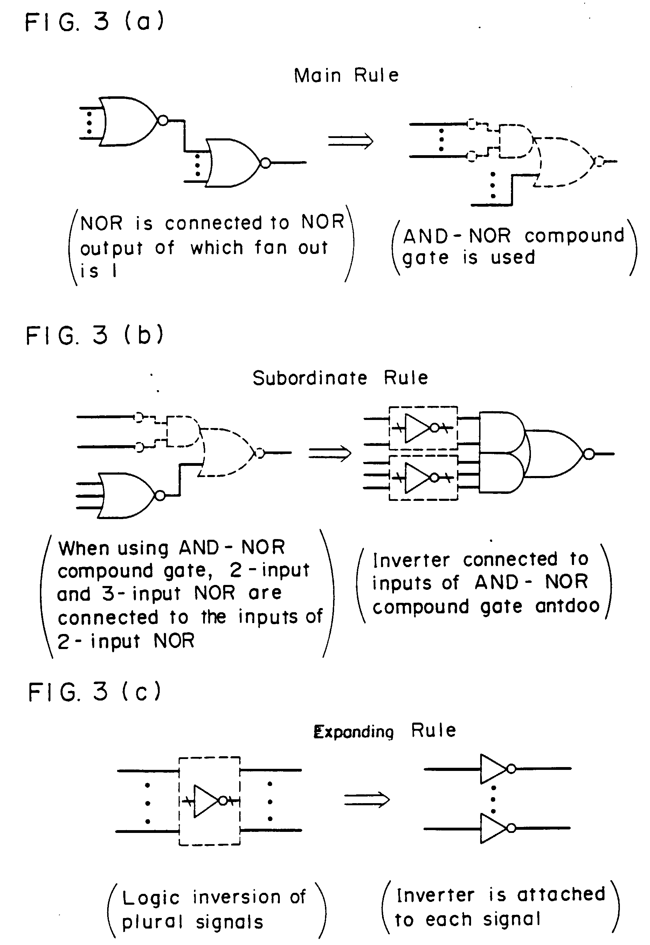

The knowledge base memory 1 stores transformation rules of plural kinds, such as general rule 10, and local rules 11, 12, etc. For example, the general rule 10 is a main rule, or a transformation rule as shown in Fig. 3(a). The local rule 11 is a subordinate rule, or a transformation rule as shown in Fig. 3(b). The subordinate rule may become a main rule of other subordinate rule. The local rule 12 is a expanding rule, such as a rule for expanding a gate having plural bit widths in every bit as shown in Fig. 3(c).

Fig. 3 shows an example of IF-THEN type rule for transformating an abstract logic circuit not depending on technology into a logically equivalent circuit composed of standard cells of CMOS type transistors. The main rule (a) in Fig. 3 expresses a general rule meaning, "If other NOR gate is connected to the output of a certain NOR gate of which fan-out is 1, an AND-NOR complex gate making rule is applied." The subordinate rule (b) in Fig. 3 is an AND-NOR complex gate making rule, and it is a local rule meaning, "If two input NORs and three input NORs are connected to two input NORs respectively, they are transformed into standard cell antd00 and inverters connected to each input." However, the inverter connected to each input is expressed in macro simplified in the logic inversion having bit widths of 2 bits and 3 bits. The expanding rule (c) in Fig. 3 is to expand the simple expression "to transform the logic inversion macro having a bit width of plural bits into inverter of each bit" into a real expression. In this embodiment, meanwhile, only two types of local rules 11, 12 are shown for the sake of simplicity, but it is also possible to use by classifying into multiple types of local rules.

The input means 2 enters the data expressing the circuit before transformation into the working memory 3.

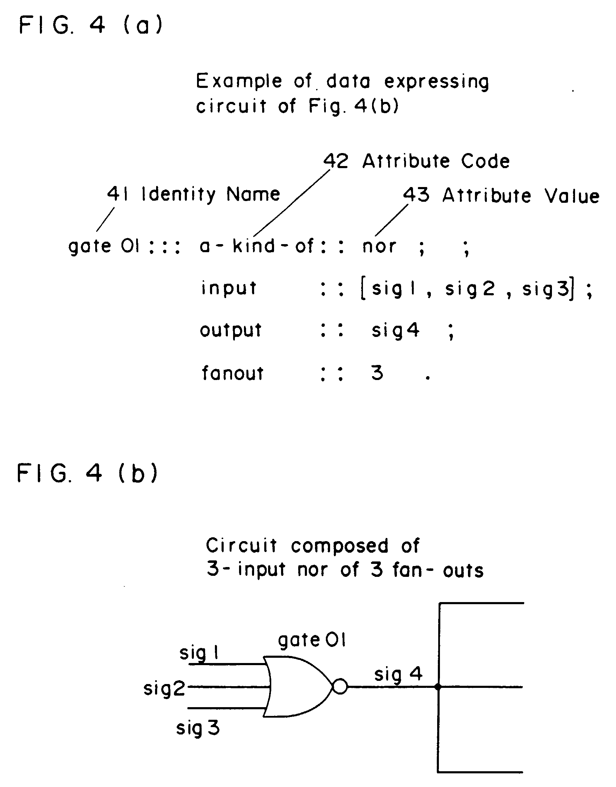

The working memory 3 stores the data expressing the circuit before transformation, circuit in the midst of transformation and circuit after transformation. An example of data expressing the circuit stored in the working memory 3 is shown in Fig. 4. Fig. 4 shows data for expressing a circuit by the input-output relation among elements, centered on elements. Fig. 4(a) is an example of data expressing the circuit of Fig. 4(b). The data is composed of, basically, identity name 41 for identifying individual elements, plural attribute codes 42, and their attribute values 43. In the example in Fig. 4(a), the pair of attribute code 42 and attribute value 43 is expressed by "::" and each pair is divided by ";". The identity name 41 is distinguished from other data by ":::". Attribute codes 42 include "a-kind-of" for expressing the type of element, "input" for expressing the input signal name, "output" for expressing the output signal name, and "fanout" for expressing fan-out. This is an example of data of the working memory 3, and as the data in the working memory 3, data expressing the circuit by paying attention to signal (that is, net) may be used, instead of the data expressing by paying attention to element as in this example.

The output 4 takes out the data expressing the circuit after transformation from the working memory 3.

The program execution means 6 stores the execution forms of various programs (or load modules) coded with programming language Prolog, Lisp, C, etc., and executes these programs by the command from the inference means 5 (particularly from the rule matching means 24 and rule applying means 28). These programs may include judgement of condition in the condition part, various calculations, procedures in the conclusion part.

The operation function of each means in the inference means 5 is explained together with the procedure of processing.

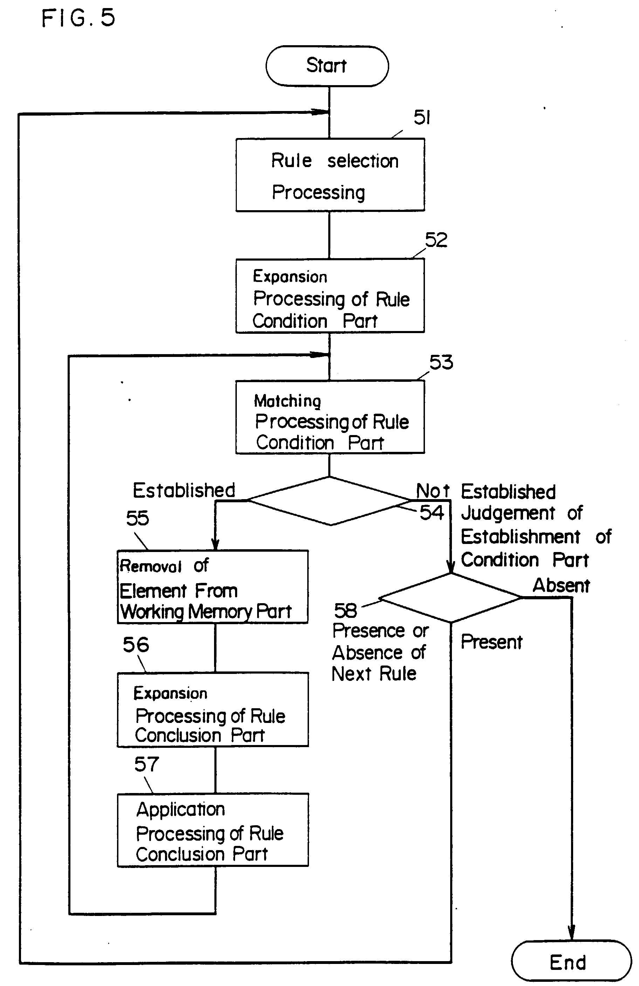

Fig. 5 is a flow chart showing an example of outline of circuit transformation processing in the inference means 5.

A processing step 51 is the part for selecting the transformation rules sequentially from the highest priority, in consideration of cancellation of competition of transformation rules, which processed by the general rule selection means 21 or local rule selection means 31 in Fig. 1. The priority order of transformation rules may be determined either beforehand for each rule, or by certain evaluation function (index) or the like.

A processing step 52 is to replace the portion matching with the condition part of the local rule 12 by its conclusion part (expansion processing of the rule condition part), within the condition part of the transformation rule selected by the previous step 51, by the rule replacing means 23 shown in Fig. 1. Types of this expansion processing include the expansion of each bit of the macro having bid width, and expand into relization of a simplified expression.

A processing step 53 is to match each term of the condition part of the transformation rule which is the output of the processing step 52 with the data in the working memory 3 in Fig. 1 by means of the rule matching means 24 (details are mentioned later).

A step 54 is to judge whether the condition part of rule is established or not by the matching processing in the processing step 53. When the judgement of this step is established, a step 55 is executed, and if not established, a step 58 is executed.

A processing step 55 is to remove the elements stored in the element storing means 26 from the data in the working memory 3 sequentially, by the element removal means 27 in Fig. 1.

A processing step 56 is to replace the portion matching with the condition part of the local rule 12 with the conclusion part of its local rule (expansion processing of the rule conclusion part), within the conclusion part of the applicable transformation rule, by the rule replacing means 23 shown in Fig. 1.

A processing step 57 is to update the data in the working memory 3, add elements, or start up the subordiante rule, by the rule applying means 28 in Fig. 1 (details of processing are mentioned later).

After this processing step 57, the operation returns to the processing step 53, and the same transformation rule is matched with the data in the working memory 3.

A step 58 is to judge whether the transformation rule to be applied next to the presently selected transformation rule is present in the knowledge base memory 1 or not. If present, the operation returns to the processing step 51, and the next transformation rule is selected. If not present, the transformation processing is terminated.

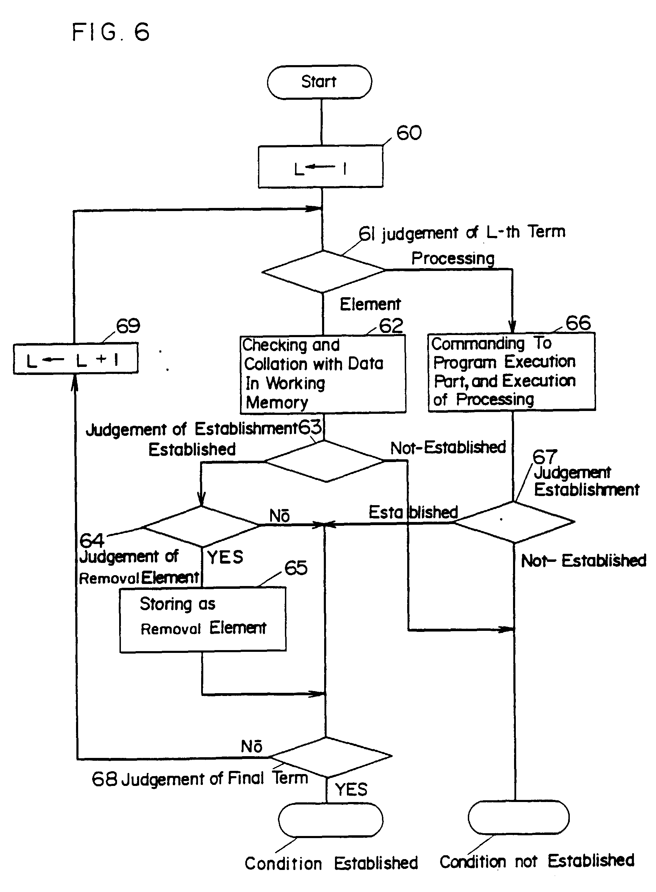

Fig. 6 is a flow chart showing an example of matching processing of the rule condition part in the step 53.

A step 60 is to specify the term to be processed in the condition part of transformation rule as the first term. That is, term number L of the processing term is No. 1.

A step 61 is to judge whether the term in processing, that is, the L-th term expresses an element or not. If the L-th term is to express an element, a step 62 is processed, and otherwise a step 66 is executed.

A step 62 is to check if the element corresponding to this L-th term is present in the working memory 3 or not, by using the element search means 25 in Fig. 1.

A step 63 is to judge whether the corresponding element was present in the foregoing step 62 or not. If present (established), a step 64 is processed, and if not present, the processing is terminated because the condition is not established.

A step 64 is to judge whether the element of which existence has been confirmed in step 62 should be deleted or not when applying this transformation rule (that is, after the rule condition is established). If the element is to be deleted, a step 65 is processed, and if not to be deleted, a step 68 is processed.

A step 65 is to store the element judged in step 64 into the element storing means 26 shown in Fig. 1. However, nothing is stored in the element storing means 26 in its initial state.

A step 66 is to execute various processings such as condition judgement represented by the L-th term, by command to the program execution means 6.

A step 67 is to judge whether the processing executed in the step 66 is established or not. If established, a step 68 is processed, and if not established, the processing is over because the condition is not established. Meanwhile, if the processing executed in step 67 does not require judgement, it is always regarded to be established.

A step 68 is to judge whether the L-th term is the final term or not. If the final term, processing is over as the condition is established, and if not final, 1 is added to L in step 69, and the processing after step 61 is executed repeatedly on the next term in the rule condition part.

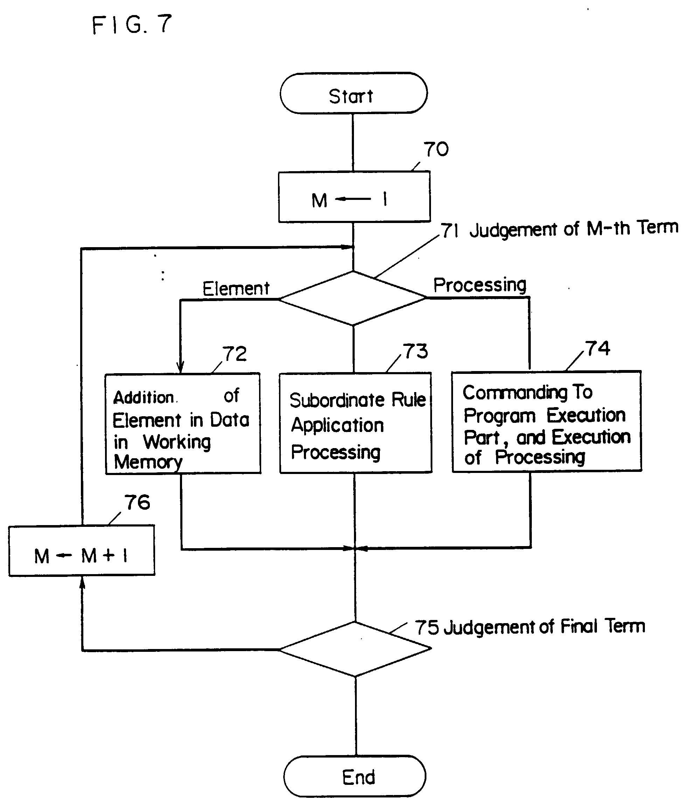

Fig. 7 is a flow chart showing an example of application processing 67 of the rule conclusion part.

A step 70 is to specify the term to be processed in the conclusion part of transformation rule as the first term. That is, the M-th processing term is No. 1.

A step 71 is to judge whether the term in processing, that is, the M-th term represents an element, does the start of subordinate rule, or does other processing. If representing an element, a step 73 is processed, if start of subordinate rule, a step 73 is processed, and if other processing, a step 74 is processed.

A step 72 is to additionally register the element judged in the foregoing step 71 to the data in the working memory 3 by the element addition means 29 shown in Fig. 1.

A step 73 is to transmit the information relating to the subordinate rule judged in the step 71 to the local rule selection means 31 by the rule requisition means 30, and executes the processing shown in the flow chart in Fig. 5 recursively, and apply the subordinate rule.

Meanwhile, when recursively executing the processing shown in the flow chart in Fig. 5, the rule selection processing 51 is particularly processed by the local rule selection means.

A step 74 is to execute the various processing judged in the step 71, by commanding to the program execution part 6.

A step 75 is to judge whether the M-th term is the final term of the rule conclusion part. If the final term, the processing is terminated, and if not final, 1 is added to M in step 76, and the processing after step 71 is repeatedly executed on the next term of the rule conclusion part.

This is the processing of the circuit transformation processing in the first embodiment of this invention. Besides, in the block diagram in Fig. 1, it is also possible to process the expansion processing 52 of the rule condition part, and expansion processing 56 of the rule conclusion part properly in the midst of processing of matching processing 53 of the rule condition part, and the application processing 57 of the rule conclusion part, respectively.

The processing shown in the flow chart in Fig. 5 can be easily realized by a high-level programming language Prolog. Prolog is explained, for example, in Programming in Prolog by W. F. Clocksim, and C. S. Mellish (Springer-Verlag, 1981). The realization by Prolog is described below.

Fig. 8 shows description examples of the transformation rules shown in Fig. 3.

That is, Fig. 8(a) is a description example of main rule in Fig. 3(a), and Fig. 8(b) is a description example of subordinate rule in Fig. 3(b). Here, the general rule 10 is expressed by "==>" and the local rule 11 by "@=>". In Fig. 8 (a), "length (L, M)" is an incorporated predicate of Prolog meaning that the length of list L is M, and "M=<N" means similarly that M is smaller than N. The symbol "@" at the right side of the rule shows the application of subordinate rule. The symbol "#" at the right side of the rule in Fig. 8(b) means that the expanding rule is applied to a term having the "#" mark, and that the rule should be replaced.

When such rule as shown in Fig. 8 is stored in the knowledge base memory 1, a series of processings of steps 53, 54, 55, 57 in the flow chart shown in Fig. 5 can be easily realized as follows by Prolog.

```
inference(LHS, RHS):-
    unify_left(LHS, L, []),        .............. (1)
    remove_gates(L),
    call(RHS).
```

That is, the first argument of "inference(LHS, RHS)" is the condition part (that is, the left side) of the selected rule, and the second argument RHS is the conclusion part (or the right side) of the rule. Furthermore, "unity_left (LHS, L, [])" realizes the step 53, "remove_gates(L)" does the step 55, and "call(RHS)" does the step 57. The judgement in the step 54 depends on whether the "unity_left" predicate is successful (true) or unsuccessful (fail). The predicate "remove_gates(L)" realizes the element removal means 27 to be done in the processing of step 55, and its argument L is a list of element to be deleted, realizing the element storing means 26.

The processing of step 53 in Fig. 6 is the predicate "unify_left(P, L1, L2)", and it can be realized as followed by Prolog.

```
unify_left((P1, P2), L1, L3):-!,
            unify_left(P1, L1, L2),
```

```
                    unify_left(P2, L2, L3).
           unify_left((Gate name:::Slots), [(Gate_name::
:Slots)1L], L):-!,
                    unify_gate(Gate, Slots).
           unify_left(?P, L, L):-!,
                    unify_left(P, _, []).
           unify_left((not P), L, L):-!,
                    not(unify_left(P, _, [])).
           unify_left(P, L, L):-
                    P.
```

In the above Prolog clauses, the first clause means that the rule condition part is recursively processed by each term, and the second clause, if the term of the rule condition part in the first argument expresses an element, retrieves to see if there is a corresponding element in the working memory 3, and if a corresponding element is found, that element is stored in the list of the third argument (step 65). Meanwhile, "unify_gates(Gate, Slots)" is a predicate realizing the element search means 25 for processing of step 62. The third clause judges the element not to be removed by "?" (step 64), and no element is stored on the list of the second argument. The fourth clause is a portion for processing the negative expression in the term of the rule condition part, which is not explained in Fig. 6, for the sake of simplicity. The fifth clause is to process the step 66. At this time, since the various processing programs are also realized by Prolog, the program execution means 6 is the processing system of Prolog (that is, the inference mechanism of Prolog) itself. Besides, because of the cut operator "!" in the third clause, if the searched element is not found in the working memory 3 (that is, the predicate "unify_gate" fails), the entire "unify_left" predicate fails.

The processing of step 57 shown in FIG. 7 is deduced by the processing system of Prolog by the predicate "call (RHS)". The judgement of step 71, and steps 72 and 73 can be easily realized as follows.

```
           (Gate_name:::Slots):-
                    add_gate(Gate_name, Slots,),!.
           @P:-!, subrule_inference(@=>, P,), !.
```

Of these clauses, the first clause processes the step 72 if the term of the conclusion part of the rule expresses an element. The predicate "add_gate(Gate_name, Slots)" realizes the element addition means 29. The second clause processes the step 73 if the term of the conclusion part of the rule expresses the application of subordinate rule. The predicate "subrule_inference(@=>, P)" is an example of realizing the rule requisition means 30. In this case, the application processing of subordinate rule may be realized easily by selecting the subordinate rule as shown below, and recursively executing the predicate" inference(Q, RHS)" to that subordinate rule.

```
           subrule_inference(Op, P):-
                    select_rule(Op, (P, Q), RHS),
                    inference(Q, RHS),!.
```

Here, the predicate "select rule(0p, (P, Q), RHS)" realizes the local rule selection means 31. For example, with respect to the rule description shown in Fig. 8, the predicate "select_rule" can be easily described as follows.

```
select_rule(Op, LHS, RHS):-
                Rule=..[Op, LHS, RHS],
                Rule.
```

Meanwhile, in the example of realizing an embodiment by Prolog shown above, the rule holding means 22 is realized by holding the condition part and conclusion part of each rule, respectively by the first argument LHS of the predicate "unify_left(LHS, L, [])" appearing in the clause (1) descriving the above predicate "inference(LHS, RHS), and the argument RHS of the predicate "call(RHS)". The general rule selection means 21 is easily realized, same as the local rule selection means 31, by using the unification function of Prolog.

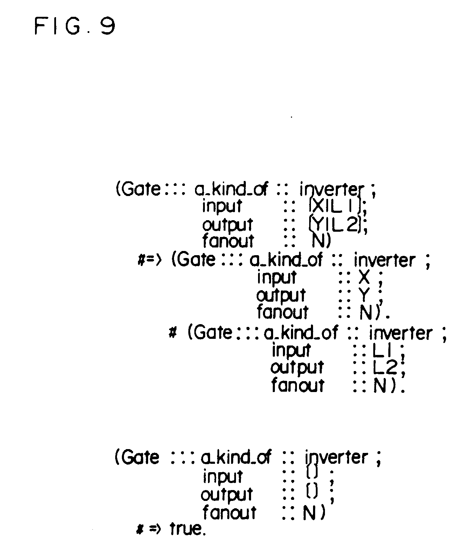

Meanwhile, the processing of step 56 shown in the flow chart in Fig. 5 is easily realized in the following cause by describing the expanding rule as shown in Fig. 9.

```
#P:-!, (P#=>Q),
        call(Q).
```

Likewise, processing of step 52 may be easily realized.

An example of description of expanding rule shown in Fig. 3(a) is indicated in Fig. 9.

Meanwhile, in the example realized by Prolog above, "@", "#", "?", "-", "not", "==>", "@=>", "#=>", ":::" and "::" are supposed to be declared by the operator.

In the above example, the embodiment is realized by using the high-level programming language Prolog, but it is also possible to realized by using other high-level programming languages, such as Lisp and C.

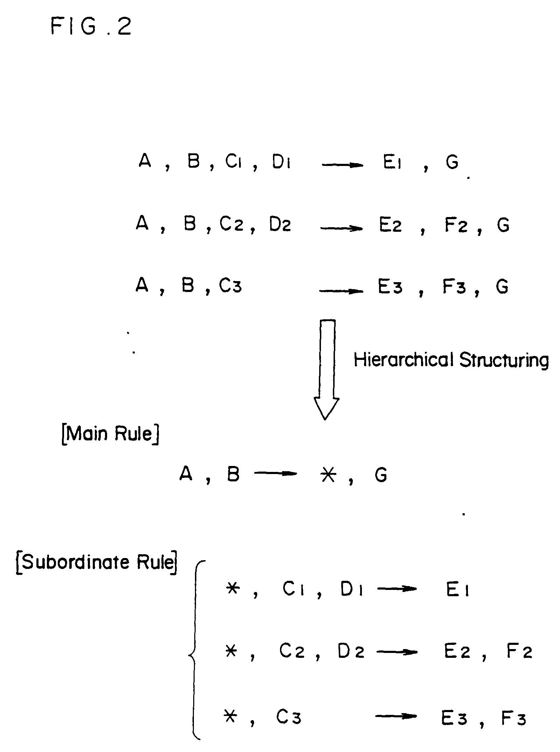

According to this embodiment, as shown in Fig. 2, it is possible to collect transformation rules differing only in part of the condition part and conclusion part, and build up these rules into a hierarchical structure comprising main rules composed of their common parts, and subordinate rules describing the differences of the individual rules, and therefore the following effects are brought about.

(1) The transformation rule may be described in a form very close to the image possessed by the designer.

(2) The rule description is simple.

(3) The quantity of description per rule can be reduced because construction of rule in step structure, and simple description of elements having bit width can be realized.

(4) Since the transformation rules can be classified, the design knowledge necessary for circuit transformation may be arranged and stored on the knowledge base.

(5) By the rule structure making, the inference efficiency is notably improved, and the processing speed is about 4 to 7 times as high as compared with the case without structure making.

## Second embodiment

A second embodiment of this invention is now described below in reference to the drawings.

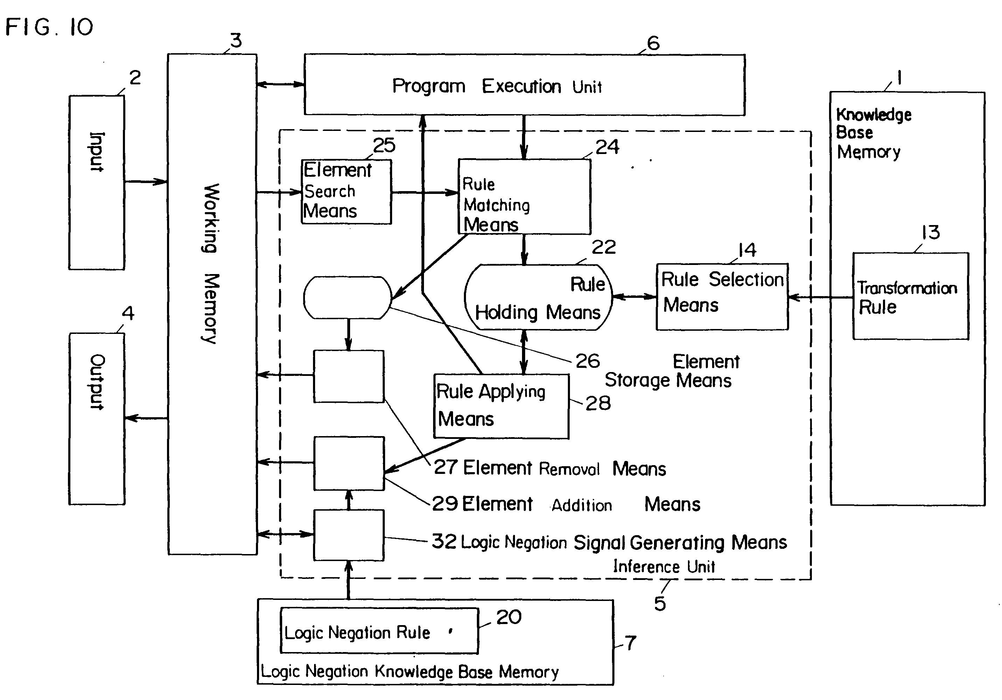

Fig. 10 is a block diagram showing a basic structure of the second embodiment of this invention, in which numeral 1 denotes a knowledge base memory, 2 is an input means, 3 is a working memory, 4 is an output means, 5 is a inference means (interpreter), 6 is a program execution means for storing programs and executing as required, and 7 is a logic negation knowledge base memory for storing the knowledge relating to the logic negation.

The inference means 5 is composed of rule selection means 14, rule holding means 22, rule matching means 24, element search means 25, element storing means 26, element removal means 27, rule applying means 28, element addition means 29, and logic negation signal generating means 32.

In this embodiment, a particularly simple rule base system example is shown, but it may be easily analogized by an other generalized rule base system. Furthermore, this invention does not depend on presence or absence of program execution. Or the transformation knowledge memory and logic negation knowledge base memory may be combined to compose a knowledge base memory (knowledge base).

These parts are described in details below.

The knowledge base memory 1 stores the transformation rule 13, for example, as shown in Fig. 20.

Fig. 20 is an example of IF-THEN type rule for transformation a technology-independent abstract logic circuit into a logically equivalent circuit composed of standard cells of CMOS transistors. That is, the rule of Fig. 20 expresses a transformation rule, meaning "If 2 input AND elements and 3 input AND elements of which fan-out is 1 are connected to both inputs of 2 input NOR elements, they are transformed into AND-NOR compound gate antdØØ."

The input means 2, working memory 3, output means 4, inference means 5, and program execution means 6 correspond to the means in the first embodiment.

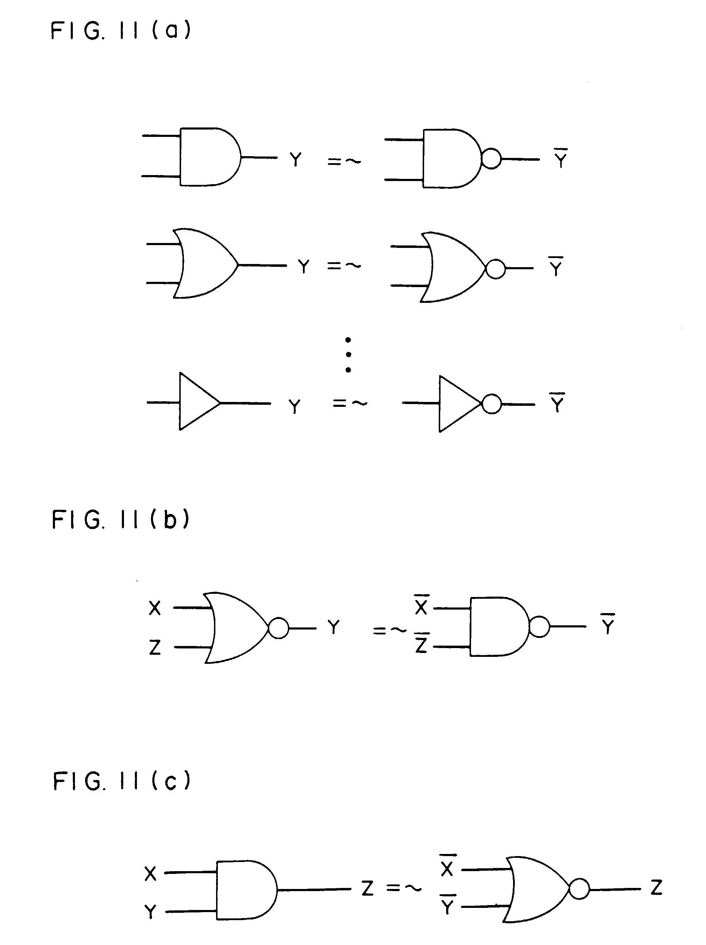

The logic negation knowledge base memory 7 stores the logic negation rule 20 indicating the logic negation relation. Examples of the logic negation rule 20 may include the rule of logically negating the output in the circuit of same input, the rule of logically negating one of the inputs in a circuit of same output of the contrary, and the rule of logically negating two outputs mutually such as in flip-flop. Fig. 11A relates to a logic negation rule, particularly a rule of logically negating the output in two circuits with same input. In the example in Fig. 11, it shows the AND element and NAND element, or OR element and NOR element, having the same inputs corresponding to each other by the symbol "=~" are mutually in the logically negated relation in their outputs. Besides, in the logic negation rule, by transforming the NOR element shown in Fig. 11B into NAND element receiving the logic negation $\bar{X}$, $\bar{Z}$ of its inputs X, Z as the inputs, the rule for generating logic negation $\bar{Y}$ of Y may be used, or with respect to the input Y of AND element as shown in Fig. 11C, the rule of generating logic negation $\bar{Y}$ of Y by the NOR element receiving the logic negation $\bar{X}$ of another input X as input may be also used.

The operation function of each means in the inference means 5 is explained below together with the processing procedure.

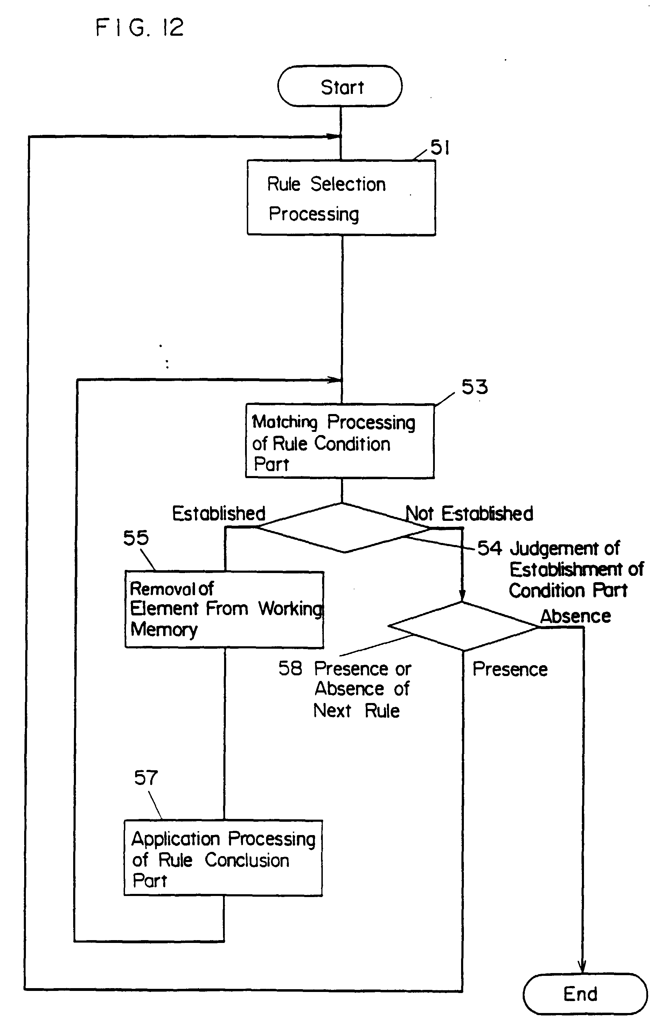

Fig. 12 is a flow chart showing an example of the outline of circuit transformation processing in the inference means 5.

A processing step 51 is to select the transformation rules sequentially in the order of priority in consideration of cancellation of competition of rules, which is processed by the rule selection means 14 in Fig. 10. The priority order of transformation rules may be either specified in advance for each rule, or determined by certain evaluation function (index) or the like.

A processing step 53 is to match each term of the condition part of the transformation rule which is the output of processing step 51 against the data in the working memory 3 in Fig. 10, by the rule matching means 24 (the details of this processing are described in Fig. 6 relating to the first embodiment).

A step 54 is to judge whether the condition part of the rule is established or not by the matching processing of step 53. If the judgement of this step is established, a step 55 is processed, and if not established, a step 58 is executed.

A processing step 55 is to remove the element stored in the element storing means 26 sequentially from the data in the working memory part 3, by the element removal means 27 in Fig. 10.

A step 57 is to update the data in the working memory 3, and add elements, by the rule applying means 28 in Fig. 10. (The details of this processing are described in Fig. 7, relating to the first embodiment.)

After this processing step 57, the operation returns to the processing step 53, and the same transformation rule is matched against the data in the working memory 3.

A step 58 is to judge whether the transformation rule to be applied next to the presently selected transformation rule is present in the knowledge base memory 1 or not. If present, the operation returns to the step 51, and the next transformation rule is selected; if not present, the transformation processing is terminated.

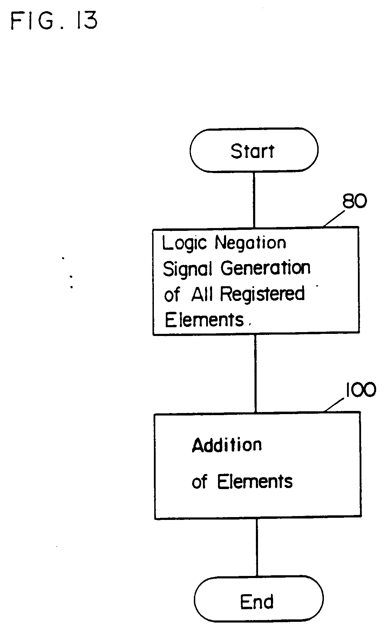

Fig. 13 is a flow chart showing the step 72 in Fig. 7 which is a principal part of this invention, and an example of negation logic generating method which is one of the inventions.

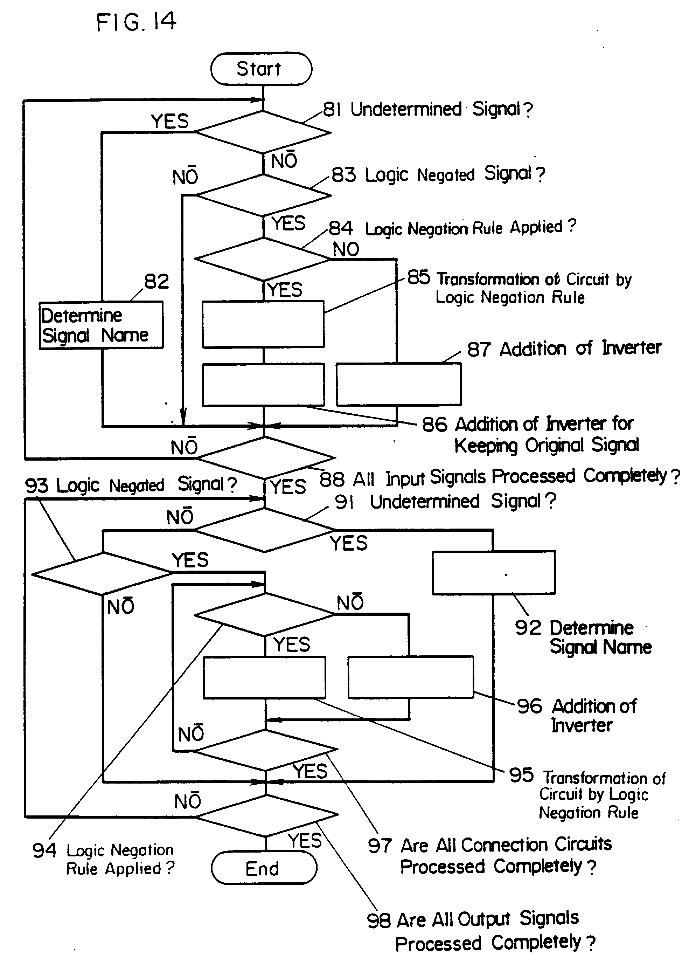

A step 80 is to, when logic negated signal $\bar{X}_i$ is used in the input signal and output signal of registered element, generate signal $Y_i$ which is a logic negation of that signal $X_i$ in the data circuit in the working memory 3. The details of processing are shown in Fig. 14.

A step 100 is to replace all logic negated signals $\bar{X}_i$ of input signals or output signals of registered element with corresponding signal $Y_i$, by using the signal $Y_i$ generated in the foregoing step 80 by the element addition means 29 in Fig. 10, and to add the element in the data in the working memory 3.

Fig. 14 is a flow chart showing the details of an example of step 80 in Fig. 13. The steps from 81 to 88 are the processing on the signals entered in the registered element, and the steps from 91 to 98 are the processing on the signals delivered from the registered element. In the example in Fig. 14, after processing on all input signals, output signals are processed. To the contrary, processing on output signals, or processing without being conscious of the sequence of input signals and output signals may be also considered. The processing is described in details below.

First, each input signal is processed from steps 81 to 87.

The step 81 is to judge whether the input signal is an undetermined signal (a signal without determined name) or not. If undetermined, as a result, the step 82 is processed, and otherwise step 83 is executed.

The step 82 is to assign a signal with a signal name.

The step 83 is to judge whether the input signal is a logic negated signal (that is, the signal is a logic negated signal (that is, the signal expressing the format of logical negation $\overline{Y}$ of a certain signal Y) or not. If it is a logical negation signal, the step 84 is processed, and otherwise the step 88 is executed.

The step 84 is to judge which one of the logic negation rules 20 in the logic negation knowledge base memory 7 is applicable for generating a logic negated signal. That is, when generating a logic negated signal $\overline{Y}$ of signal Y, it is judged whether the circuit which is either the left side (the left side of "=~') or the right side of the logic negation rule shown in Fig. 11A (or Fig. 11B) and of which output signal is Y is present in the data circuit in the working memory 3 (that is, whether matched with pattern) or not. For instance, in the example in Fig. 11A, it is judged whether 2-input AND circuit, 2-input OR circuit or the like having output signal Y is present in the data circuit in the working memory 3, or not. If present, as a result, the logic negation rule is applicable, and step 85 is executed, and if not present in any rule, step 87 is executed.

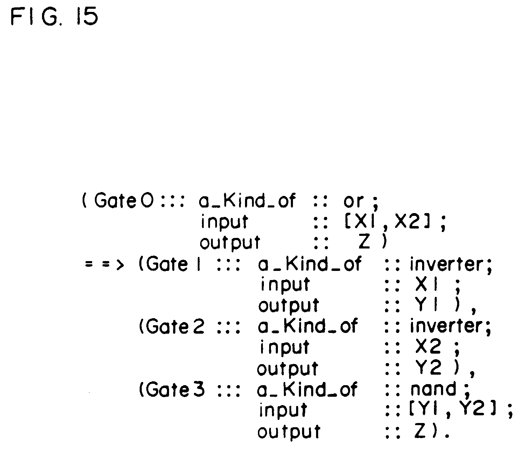

The step 85 is to remove the circuit at the left side or right side (as matched in the previous step) of the logic negation rule judged to be applicable in the foregoing step 84, from the data in the working memory 3, and the corresponding right side or left side of the rule is additionally registered in the working memory 3. For example, in step 84, if the first rule in Fig. 11A can be applied, the AND element of the output signal Y confirmed to be present in the step 84 is removed from the working memory part 3, and the NAND element of the corresponding same input signal is additionally registered in the working memory 3. removal of element is same as in step 55 in Fig. 12. addition of element may be also realized by recursively executing step 72 in Fig. 15.

The step 86 is to additionally register the inverter having input signal $\overline{Y}$ and output signal Y in the working memory 3, in order to keep the signal Y removed by the processing of the previous step 85. It is, however, not necessary to additionally register the inverter unless an element having this signal Y as input signal is present in the data circuit in the working memory 3 after the processing of step 85.

In the step 85, meanwhile, when transforming the inverter into a buffer (that is, when the inverter having input signal Y or output signal Y is present in the data circuit), since the output signal or input signal of the inverter is logic negated signal $\overline{Y}$, the step 85 is only to pick up the logic negated signal $\overline{Y}$, and the step 86 may be omitted. Likewise, if a flip-flop having an output signal Y is present in the data circuit, the step 85 is only to pick up the inverted signal $\overline{Y}$, and the step 86 is omitted.

The step 87 is to generate a logic negated signal $\overline{Y}$ by additionally registering the inverter of input signal Y into the data in the working memory 3, if any logic negation rule cannot be applied in step 84.

Addition of inverter in steps 86, 87 can be realized by recursively executing the step 72 in Fig. 7.

The step 88 is to judge whether the processing of steps 81 to 87 has been effected on all input signals of the registered element or not. If processed on all input signals, the output signals are processed (steps 91 to 98); otherwise, steps 81 to 87 are executed again on unprocessed input signals.

For output signals, similarly, steps 91 to 87 are executed.

The steps 91, 92, 93 are same as the preceding steps 81, 82, 83, and are not explained herein.

The step 94 is to judge similarly to step 84, which one of the logic negation rules 20 in the logic negation knowledge base memory 7 is applicable for generating logic negated signals. That is, when generating logic negated signal of signal Y, it is judged whether the circuit located at either left side or right side of any one of the logic negation rules and one of which input signals is signal Y is matched with the pattern of the data in the working memory 3 or not. If matched, as a result, the step 95 is executed; otherwise, the step 96 is executed.

The step 95 is to generate a desired logic negated signal, by using the logic negation rule which is judged to be applicable in the step 94, same as in step 84. For example, if the 2-input AND element at the left side of the logic negation rule in Fig. 11C is matched in pattern, the element is removed from the working memory 3, and a NOR element having same output signal and also input signals $\overline{X}$, $\overline{Y}$ is additionally registered in the working memory 3. Removal of element is same as in step 55 in Fig. 12. addition of element is realized by recursively executing step 72 in Fig. 7.

The step 96, similarly to step 87, is to generate an logic negated signals $\overline{Y}$ by additionally registering the inverter of output signal Y in the data in the working memory 3, if any logic negation rule cannot be applied in step 94.

In step 94, however, if matched in pattern with the inverter having input signal Y, if plural elements receiving signal Y as input are present in the step 95, since the output signal of the inverter is $\overline{Y}$, only the logic negated signal $\overline{Y}$ is picked up, and the inverter is not deleted.

The step 97 is to process the steps 94 to 96 repeatedly if the logic negated signal $\overline{Y}$ has plural element inputs (that is, the fan-out is plural). When processing of steps 94 to 96 is over on all elements receiving the signals to be logically negated as inputs, the step 98 is executed; otherwise, steps 94 to 96 are executed on the unprocessed portion.

The step 98 is to judge in order to execute steps 91 to 97 repeatedly individually if the registered element has plural output signals, same as in step 88 above.

Of these steps, the steps 84 to 87 on input signals, and steps 94 to 97 on output signals are effected by the logic negation signal generating means in Fig. 10.

In the above examples, generation of logic negated signal of both input and output signals was taken into consideration, but it is also possible to realize easily in the case of input signal only or output signal only.

Explained so far is the circuit transformation processing in the second embodiment. Meanwhile, the processing in the flow chart in Fig. 5 may be reasily realized by Prolog, exactly in the same manner as in the first embodiment.

An example of realizing logic negation generating method (by Prolog) is briefly described below.

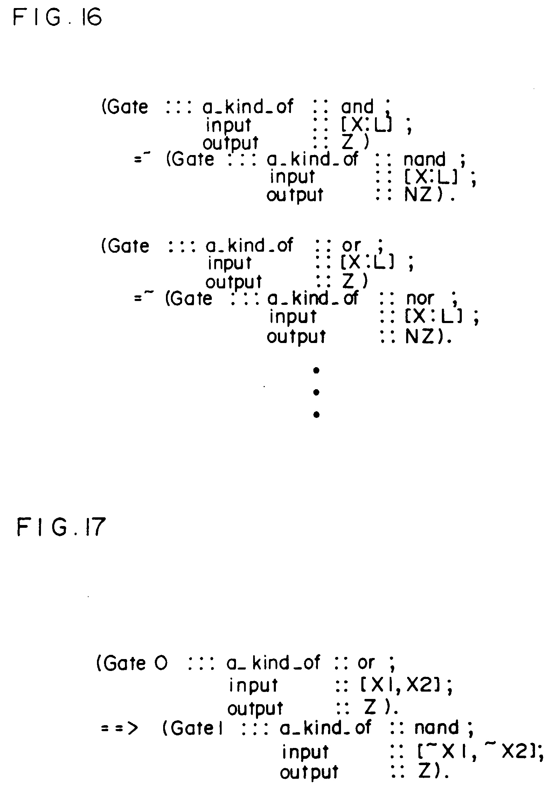

Fig. 16 is a description example of a logic negation rule shown in Fig. 11A.

For example, when the logic negation rule shown in Fig. 16 is stored in the logic negation knowledge base memory 7, a series of processing in steps 84, 85, 86, 87 shown in the flow chart in Fig. 14 may be easily realized as follows by Prolog.

```
reverse_logic(X, Z):-
    P=(G:::a_kind_of::_;_::X;_),
    Q=(G:::a_kind_of::_;_::Z;_),
    select_rule('=ν', P, Q),
    unify_left(P, [P], []),
    replace_gate(P, Q),!,
reverse_logic(X, Z):-
    create_inverter((input::X;output::Z)).
```

That is, the predicate "reverse_logic(X, Y)" means that the logic negated signal of signal X of the first argument is signal Z of the second argument. At this time, the step 84 in Fig. 14 is realized by the predicate "select_rule( $_ = ν _$, P, Q)" and the predicate "unify_left(P, [P], [])" in the first clause. Meanwhile, the predicate "replace_gate(P, Q)" realizes the steps 85, 86. An example of predicate "replace_gate" is shown below.

```
replace_gate((_:::a_kind_of::inverter;_;_::_),_):-!.
```

```
replace_gate((_:::_;output(Q)::_;output(*Q)::_),_):_!.
replace_gate(P, Q):_
    P=(G:::a_kind_of::kind;_::X;_),
    Q=(_:::_;_::Z;_),
    remove_frame(G),
    call(Q),
    create_inverter((input::Z;output::X)).
```

The first clause corresponds to a case of transforming the inverter into a buffer stated above, while the second clause corresponds to a case where a flip-flop exists. In the second clause *Q means the terminal for delivering the logic negated signal of the output signal of output terminal Q. In the third clause, the predicate "remove_frame(G)" and the predicate "call(Q)" realize the step 85, and the predicate "create_inverter (input::Z;output::X)' realizes the step 86.

The second clause in the above predicate "reverse_logic(X, Z)" is the portion for executing the additional processing (step 87) of the inverter when the logic negation rule cannot be applied.

The predicate "create_inverter" is for additionally registering the inverter in the working memory 3, which is easily realized as follows.

```
create_inverter(Slots):_
    call((_:::a_kind_of::inverter;Slots)).
```

By effectively utilizing the logic negation signal generation means realized in Prolog, for example, the description example of Fig. 15 can express the conslusion part of the rule very simply by using the logic negated signal as shown in Fig. 17. In Fig. 17, the symbol "~" (or "-" means the logic negation. That is, "~X" means and logic negated signal of signal X. Besides, at step 83 and step 93 in Fig. 14, the judgement of whether or not logic negated signal may be easily realized by judging if "~" is attached to the signal name or not. Meanwhile, in Fig. 17, it may be also considered to described simply "~[X1, X2]" instead of "[~X1, ~X2]".

Furthermore, the judgement of undetermined signal (step 81 and step 91) may be realized by judging if the signal name is a variable or not, by using the incorporated predicate "var(X)" of Prolog. In the determination of signal name in steps 82 and 92, a signal name may be easily generated by the predicate "gensym" which is a basic predicate of Prolog.

In addition, the logic negated logic generating method to the output signal (steps 94, 95, 96, 97 in Fig. 14) may be also realized easily as in the case of input signal.

In the above examples realized by Prolog, "-", "not", "==>", ":::" and "::" are supposed to be declared by the operator.

In these examples, the embodiment was realized by using the high-level programming language Prolog, but it is also possible to realize by other high-level programming languages such as Lisp and C.

According to this embodiment, since logic negated signals can be used in the transformation rules, and it is not necessary to be conscious of the generating method of logic negated signals, the following effects are brought about.

(1) The transformation rule may be described in a form very close to the image possessed by the designer.

(2) The rule description is simple.

(3) The quantity of description per rule can be reduced because construction of rule in step structure, and simple description of elements having bit width can be realized.

(4) Since the transformation rules can be classified, the design knowledge necessary for circuit transfromation may be arranged and stored on the knowledge base.

(5) By automatic generation of logic negated signal, the inference efficiency is notably enhanced, and the processing speed may be increased.

Third embodiment

A third embodiment of this invention is described below while referring to the accompanying drawings.

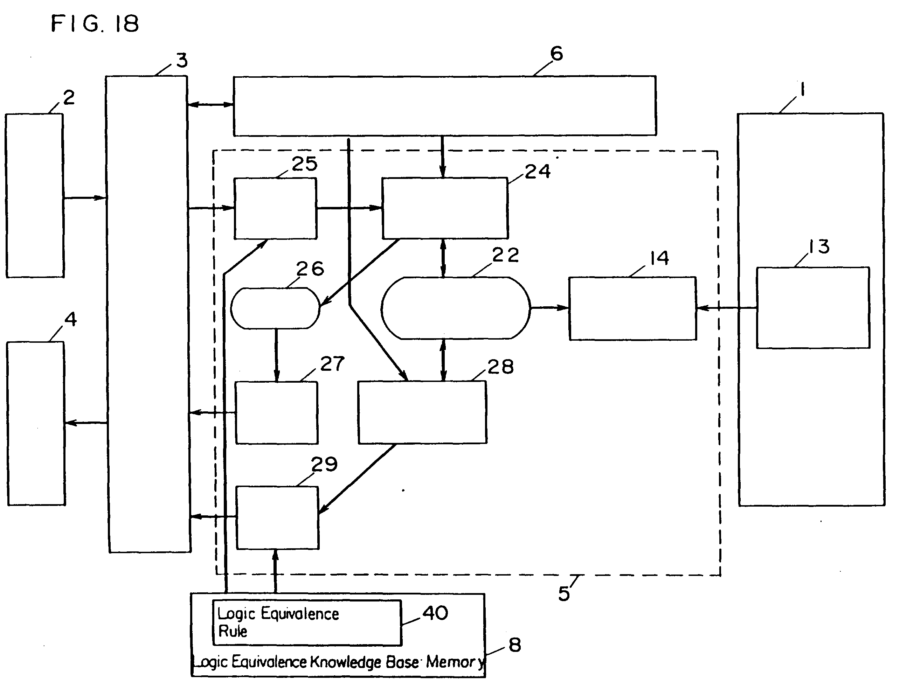

Fig. 18 is a block diagram showing a basic structure of the third embodiment of this invention, in which numeral 1 denotes knowledge base memory, 2 is an input means, 3 is a working memory, 4 is an output means, 5 is a inference means (interpreter), 6 is a program execution means for storing programs and executing as required, and 8 is logic equivalence knowledge base memory for storing the knowledge about logic equivalence.

The inference means 5 is composed of rule selection means 14, rule holding means 22, rule matching means 24, element search means 25, element storing means 26, element removal means 27, rule applying means 28, and element addition means 29.

In this embodiment, an example of particularly simple rule base system is shown, but it may be easily analogized by an other generalized rule base system. This invention, meanwhile, does not depend on the presence or absence of program execution means, and the knowledge base memory and logic equivalence knownledge base memory may be combined to compose knowledge base memory (knowledge base).

These parts are described in details below.

The knowledge base memory 1, input means 2, working memory 3, output means 4, inference means 5, and program execution means 6 correspond to the parts in the first and second embodiments above.

The logic equivalence knowledge base memory 8 stores logic equivalence rule 40 showing a logically equivalent relation. Fig. 19 is an example of logic equivalence rule. In the example in Fig. 19, it shows that "AND" and "logic negation of output of NAND", and "AND" and "NOR by logic negation of its input" indicated in corresponding relation by the symbol "=" are in equivalent logic relation, respectively.

The operation function of each means in the inference means 5 is explained together with the procedure of processing.

Fig. 12 is a flow chart showing an example of outline of circuit transformation processing in the inference means 5.

A processing step 51 is the part for selecting the transformation rules sequentially from the highest priority, in consideration of cancellation of competition of transformation rules, which is processed by the rule selection means 14 in Fig. 18. The priority order to transformation rules may be determined either beforehand for each rule, or by certain evaluation function (index) or the like.

A processing step 53 is to match each term of the condition part of the transformation rule which is the output of the processing step 51 with the data in the working memory 3 in Fig. 18 by means of the rule matching means 24 (details are mentioned later).

A step 54 is to judge whether the condition part of rule is established or not by the matching processing in the processing step 53. When the judgement of this step is established, a step 55 is executed, and if not established, a step 58 is executed.

A processing step 55 is to remove the elements stored in the element storing means 26 from the data in the working memory 3 sequentially, by the element removal means 27 in Fig. 18.

A processing step 57 is to update the data in the working memory 3, or add elements, by the rule applying means 28 in Fig. 18 (details of processing are mentioned later).

After this processing step 57, the operation returns to the processing step 53, and the same transformation rule is matched with the data in the working memory 3.

A step 58 is to judge whether the transformation rule to be applied next to the presently selected transformation rule is present in the knowledge base memory 1 or not. If present, the operation returns to the processing step 51, and the next transformation rule is selected. If not present, the transformation processing is terminated.

Fig. 6 is a flow chart showing an example of matching processing of the rule condition part in the step 53.

A step 60 is to sepcify the term to be processed in the condition part of transformation rule as the first term. That is, term number L of the processing term is No. 1.

A step 61 is to judge whether the term in processing, that is, the L-th term expresses an element or not. If the L-th term is to express an element, a step 62 is processed, and otherwise a step 66 is executed.

A step 62 is to check if the element corresponding to this L-th term is present in the working memory 3 or not, by using the element search means 25 in Fig. 18.

If the element corresponding to the L-th term is not present in the working memory 3, and if there is an logic equivalence rule relating to the element of the L-th term in the logic equivalence rule 40 stored in the logic equivalence knowledge base memory 8, this rule is used, and it is checked whether any circuit logically equivalent to the L-th element (that is, the circuit composed of a single element or plural elements) is present in the working memory 3 or not. If present, this circuit is used instead of the L-th element, and the subsequent processing is carried out.

A step 63 is to judge whether the corresponding element (in its substitute circuit) was present in the foregoing step 62 or not. If present (established), a step 64 is processed, and if not present, the processing is terminated because the condition is not established.

A step 64 is to judge whether the element of which existence has been confirmed in step 62 should be removed or not when applying this transformation rule (that is, after the rule condition is established). If the element is to be removed, a step 65 is processed, and if not to be removed, a step 68 is processed.

A step 65 is to store the element judged in step 64 into the element storing means 26 shown in Fig. 18. However, nothing is stored in the element storing means 26 in its initial state.

A step 66 is to execute various processings such as condition judgement represented by the L-th term, by command to the program execution means 6.

A step 67 is to judge whether the processing executed in the step 66 is established or not. If established, a step 68 is processed, and if not established, the processing is over because the condition is not established. Meanwhile, if the processing executed in step 67 does not require judgement, it is always regarded to be established.

A step 68 is to judge whether the L-th term is the final term or not. If the final term, processing is over as the condition is established, and if not final, 1 is added to L in step 69, and the processing after step 61 is executed repeatedly on the next term in the rule condition part.

Fig. 7 is a flow chart showing an example of application processing 67 of the rule conclusion part.

A step 70 is to specify the term to be processed in the conclusion part of transformation rule as the first term. That is, the M-th processing term is No. 1.

A step 71 is to judge whether the term in processing, that is, the M-th term represents an element, does the start of subordinate rule, or does other processing. If representing an element, a step 73 is processed, if start of subordinate rule, a step 73 is processed, and if other processing, a step 74 is processed.

A step 72 is to additionally register the element judged in the foregoing step 71 to the data in the working memory 3 by the element addition means 29 shown in Fig. 18.

If the element to be additionally registered is not suitable as the element to compose the circuit after transformation, and if there is a logic equivalence rule relating to that element in the logic equivalence rule 40 stored in the logic equivalence knowledge base memory 8, that rule is used, and instead of the element to be additionally registered, a circuit which is equivalent to the element logically and is appropriate (that is, a circuit composed of single element or plural elements) is additionally registered to the working memory 3.

A step 74 is to execute the various processing judged in the step 71, by commanding to the program execution means 6.

A step 75 is to judge whether the M-th term is the final term of the rule conclusion part. If the final term, the processing is terminated, and if not final, 1 is added to M in step 76, and the processing after step 71 is repeatedly executed on the next term of the rule conclusion part.

This ends the explanation of the circuit transformation processing in the third embodiment. Next, the circuit transformation processing by employing the circuit transformation method of this invention is described below together with practical examples.

Fig. 22 is an example showing part of the circuit stored in the working memory 3 in the foregoing embodiment. In the circuit in Fig. 22, inverter 101, inverter 102, NOR 103, NAND 104, inverter 105, and NOR 106 can be transformed into AND-NOR complex gate antd00.

In the conventional transforming method, this transformation can be realized in two manners.

(1) The first manner is to make a transformation rule as shown in Fig. 23 which is logically equivalent to the rule to be transformed into the AND-NOR complex gate shown in Fig. 20, and apply it to the circuit in Fig. 22.

In this method, as evident by comparing the transformation rule in Fig. 20 with the transformation rule in Fig. 23, the transformation rule is complicated, and it is necessary to make a rule corresponding to each case.

(2) In the second manner, first applying the transformation rules a and b shown in Fig. 24, the inverter 101 and inverter 102 and NOR 103, and NAND 104 and inverter 105 shown in Fig. 22 are respectively transformed into 2-input AND and 3-input AND, and then the transformation rule shown in Fig. 20 is applied.

In this method, the individual transformation rules are simple, as compared with the first manner, but it is necessary to transform three times while once is enough in the first manner, and the number of rules is increased and the access to the working memory 3 is often required.

The method of this invention can solve the conventional problems. That is, when the transformation rule shown in Fig. 20 is applied to the circuit in Fig. 22, the inverter 101 and inverter 102 and NOR 103 are recognized as 2-input AND by using the logic equivalence rule (b) shown in Fig. 19, and the NAND 104 and inverter 105 are recognized as 3-input AND by using the logic equivalence rule (a) in Fig. 19, thereby transforming circuits and generating a circuit as shown in Fig. 25.

According to this embodiment, by effectively utilizing the simple logic equivalence rules, multiple processings are possibles with a small number of simple rules, and hence the following effects are brough about.

(1) The transformation rule may be described in a form very close to the image possessed by the designer.

(2) The rule description is simple.

(3) The quality of description per rule can be reduced, while the number of transformation rules is decreased.

(4) Since transformation rules can be classified, the design knowledge necessary for circuit transformation can be arranged and stored in the knowledge base.

(5) The inference efficiency is notably increased by the use of logic equivalence rule, so that the processing speed may be increased, too.

Meanwhile, relating to the embodiments of logic designing system employing the circuit transformation method of the first, second or third embodiment described herein, the function description translating means for translating the function description in hardware language into connection information of function block is specifically described in the Japanese Patent Application No. 62-241289; and the circuit transformation means for transforming the connection information of function block into connection information of circuit or logic circuit may be easily realized by the embodiments of this invention.

As explained hereabove by referring to three embodiments, according to this invention, in the circuit transformation or logic design necessary when mounting circuits possessing same function by different technologies (or devices), the transformation knowledge possessed by the designer can be easily taken into the system by describing by a rule in a simple format, and the circuit transformation processing by computer may be carried out at high quality as proficiently as the skilled designer, while the processing speed may be increased by the efficient inference. Furthermore it is also possible to cope with technology changes. Accordingly, the designing manpower and cost are reduced, and the design quality is enhanced.

While specific embodiments of the invention have been illustrated and described herein, it is realized that other modifications and changes will occur to those skilled in the art within the scope of the invention as defined by the appended claims.

## Claims

1. A method of transforming a first circuit constituted by a first set of elements into a logically equivalent second circuit constituted by a second set of elements, comprising

   selecting (51) a candidate rule from a knowledge base memory (1) storing transformation rules (10,11,12) comprising general rules (10) and local rules (11,12), each rule being expressed by a formula with a condition part and a conclusion part;
   expanding (52) the condition part of said candidate rule by replacing a portion of said condition part which matches the condition part of a local rule by the conclusion part of the local rule;
   matching (53) the expanded condition part of said candidate rule to circuit data stored in a working memory (3);
   judging (54) the applicability of said candidate rule;
   removing (55) the elements of the condition part of said candidate rule from said circuit data in said working memory (3);
   expanding (56) the conclusion part of said candidate rule by replacing a portion of said conclusion part which matches the condition part of a local rule by the conclusion part of the local rule; and
   applying (57) said candidate rule, in which the condition part and conclusion part have been expanded, to the circuit data in said working memory (3), after confirming the applicability of said candidate rule.

2. A method according to claim 1, wherein said step of applying said candidate rule (57) comprises

   registering (72) the elements which are extracted from elements described in the conclusion part of said candidate rule into the circuit data stored in said working memory (3);
   selecting and applying (73) the local rule (12) stored in the knowledge base memory (1) as instructed by said candidate rule.

3. A logic design system for transforming a first circuit constituted by a first set of elements into a logically equivalent second circuit constituted by a second set of elements, comprising

   knowledge base memory means (1) for storing circuit transformation rules (10,11,12), comprising general rules (10) and local rules (11,12), each of the transformation rules being expressed by a formula with a condition part and a conclusion part;
   input means (2) for entering a functional description and for translating said functional description into circuit data;
   working memory means (3) for storing said circuit data;
   output means (4) for delivering circuit data from said working memory (3);
   inference means (5) for inferring the second set of elements on the basis of said transformation rules;
   program execution means (6) for storing and executing programs to control operations of the system, including judgements, operations and functions according to said transformation rules (10,11,12),
   and said inference means (5) comprising,
   rule selection means (21) and local rule selection means (31) for selecting a candidate rule from the transformation rules (10,11,12);
   rule holding means (22) for holding said candidate rule;
   rule replacing means (23) for expanding the condition part and the conclusion part of said candidate rule by replacing a portion of the respective part which matches the condition part of a local rule by the conclusion part of the local rule;
   element search means (25) for searching for elements in the circuit data stored in said working memory (3);
   rule matching means (24) for comparing the expanded condition part of said candidate rule with the circuit data in said working memory 93), using said element search means (25) and said program execution means (6), and for checking the applicability of said candidate rule;

element storing means (26) for extracting elements to be removed according to elements described in said candidate rule, and for storing said extracted elements;

element removal means (27) for sequentially removing the elements extracted and stored in said element storing means (26), from the circuit data stored in said working memory (3), after the applicability of said candidate rule is established by said rule matching means (24);

rule applying means (28) for updating the data in said working memory (3) through additionally registering the elements described in said expanded conclusion part by said program execution means (6), after confirming said applicability; and

element addition means (29) for additionally registering the element which is extracted from elements described in the expanded conclusion part of said candidate rule, into the data stored in said working memory (3); and

rule requisition means (30) for causing said local rule selection means (31) to select a new transformation rule to be applied and to transmit it to said rule holding means (22), as necessary according to the conclusion part of said candidate rule which was last applied by said rule applying means (28).

4. A logic design system according to claim 3, wherein said inference means (5) further comprises

rule replacing means (23) for replacing a part or a whole of a candidate rule held in the rule holding means (22), with another transformation rule which matches said part or whole of said candidate rule.

5. A logic design system according to claim 3 or 4, wherein the element storing means (26) extracts elements to be removed according to elements described in said candidate rule, and stores them.

6. A method of transforming a first circuit constituted by a first set of elements into a logically equivalent circuit constituted by a second set of elements, comprising:

selecting (51) a candidate rule from a knowledge base memory (1) storing transformation rules (13), each rule being expressed by a formula with a condition part and a conclusion part;

matching (53) a candidate rule to circuit data stored in a working memory (3);

checking (54) the applicability of said candidate rule;

applying (57) said candidate rule to the circuit data for transforming the circuit after confirming the applicability of the candidate rule, wherein this step of applying said candidate rule comprises the steps of,

judging (81,83,91,93) whether each signal of output/input signals of an element expresses a logic negation of a specific signal and extracting said signal when the element is being additionally registered through transforming into the circuit data stored in said working memory (3);

updating (85,95) the circuit data and extracting said signal from the circuit data according to a logic negation rule selected from a logic negation knowledge base memory (7) storing logic negation rules (20) which relate a logic circuit to another logic circuit with at least one of plural negated output/input signals, if the logic negation is judged to be applicable, said signal being equivalent to the logic negation of said specific signal; and

generating (87,96) said signal by adding an inverter which accepts said specific signal, to the circuit data, if the logic negation rule is judged to be inapplicable.

7. A method according to Claim 6 in which said steps of judging, updating and generating comprise:

judging (83) if an input signal of a circuit element is a logic negation signal ($\sim Yi$);

judging (84) whether a logic negation rule, stored in a logic negation knowledge base memory (7), is applicable to another circuit giving a signal (Yi) to generate said logic negation signal ($\sim Yi$);

updating (85) said other circuit data according to said logic negation rule, if the logic negation rule is judged to be applicable in said judging step (84); and

adding (87) an inverter, which inputs signal (Yi), to the circuit data, and generating said logic negation signal ($\sim Yi$), if the logic negation rule is judged to be inapplicable in said judging step (84);

extracting (93) a logic negation signal ($\sim Yi$) from output signal of a circuit element stored in a working memory (3);

judging (94) whether a logic negation rule, stored in a logic negation knowledge base memory (7), is applicable to the other circuit stored in working memory (3) inputting a signal (Yi) to input said logic negation signal ($\sim Yi$);

updating (95) said other circuit data according to said logic negation rule, if the logic negation rule is judged to be applicable in said judging step (93); and

adding (96) an inverter, which inputs signal (Yi), to the circuit data, and generating said logic negation signal

($\sim$Yi), if the logic negation rule is judged to be inapplicable in said judging step (94).

8. A logic design system for transforming a first circuit constituted by a first set of elements into a logically equivalent second circuit constituted by a second set of elements, comprising

a knowledge base memory means (1) for storing circuit transformation rules (13), each of the transformation rules being expressed by a formula with a condition part and a conclusion part;
input means (2) for entering a functional description and for translating said functional description into circuit data;
working memory means (3) for storing said circuit data;
output means (4) for delivering circuit data from said working memory (3);
inference means (5) for inferring the second set of elements on the basis of said transformation rules;
program execution means (6) for storing and executing programs of processing operations including judgements, operations and functions according to said transformation rules (13), and
logic negation knowledge base memory (7) for storing logic negation rules (20) which relate a logic circuit to another logic circuit with at least one of plural negated output/input signals,
and said inference means (5) comprising,
rule selection means (14) for selecting a candidate rule from the transformation rules (13);
rule holding means (22) for holding said candidate rule;
element search means (25) for searching for elements in the circuit data stored in said working memory (3);
rule matching means (24) for comparing the condition part of said candidate rule with the circuit data in said working memory (3), using said element search means (25) and said program execution means (6), and for checking the application of said candidate rule;
element storing means (26) for extracting elements to be removed according to elements described in said candidate rule, and for storing said extracted elements;
element removal means (27) for sequentially removing the elements extracted and stored in said element storing means (26), from the circuit data stored in said working memory (3) after the applicability of said candidate rule is established by said rule matching means (24);
rule applying means (28) for updating the data in said working memory (3) through additionally registering elements described in said conclusion part by element addition means (29) and said program execution means (6), after confirming said applicability; and
element addition means (29) for additionally registering the element which is extracted from elements described in the conclusion part of said candidate rule, into the data stored in said working memory (3); and
logic negation signal generating means (32) for generating the logic negation signal of a specific signal from the data to be stored in said working memory (3) by making use of said logic negation rules (20).

9. A logic design system according to claim 8, wherein said element addition means (29) includes
judging means for judging whether each of the output or input signals of an element to be additionally registered expresses logic negation of specific signal, and for extracting said signal.

10. A logic design system according to claim 8 or 9, wherein said element addition means (29) includes
assignment means for assigning a new signal name to undetermined output or input signals of the element to be additionally registered.

11. A method of transforming a first circuit constituted by a first set of elements into a logically equivalent second circuit constituted by a second set of elements, comprising

selecting (51) a candidate rule from a knowledge base memory (1) storing transformation rules (13), each rule being expressed by a formula with a condition part and a conclusion part;
matching (53) said candidate rule to circuit data stored in a working memory (3);
judging (54) the applicability of said candidate rule; and
applying (57) said candidate rule to the circuit data for transforming the circuit, after confirming the applicability of the candidate rule;
recognizing a subcircuit of the circuit data as a circuit logically equivalent to a circuit described in the condition part in said candidate rule, when said applicability is not confirmed, by using a logic equivalence rule (40) which is stored in a logic equivalence knowledge base memory (8).

12. A method according to claim 11, wherein said step (57) of applying said candidate rule further comprises

generating a subcircuit, in the circuit data, which is logically equivalent to a circuit described in the conclusion part of said candidate rule, by using a logic equivalence rule (40) which is stored in said logic equivalence knowledge base memory (8).

**13.** A logic design system for transforming a first circuit constituted by a first set of elements into a logically equivalent second circuit constituted by a second set of elements, comprising

a knowledge base memory means (1) for storing circuit transformation rules (13), each of the transformation rules being expressed by a formula with a condition part and a conclusion part;

input means (2) for entering a functional description and for translating said functional description into circuit data,

working memory means (3) for storing said circuit data;

output means (4) for delivering circuit data from said working memory (3);

inference means (5) for inferring the second set of elements on the basis of said transformation rules;

program execution means (6) for storing and executing programs of processing operations including judgements, operations and functions according to said transformation rules (13),

logic equivalence knowledge base memory (8) for storing logic equivalence rules (40) which express that a circuit is logically equivalent to another circuit; and

said inference means (5) comprising,

rule selection means (14) for selecting a candidate rule, the candidate rule being one of the transformation rules (13);

rule holding means (22) for holding said candidate rule;

element search means (25) for searching for an element in circuit data stored in said working memory (3);

circuit recognition means (8,25) for recognizing a subcircuit of data as a circuit logically equivalent to a portion of condition part of said candidate rule and one of said equivalence rule (40) stored in said equivalent knowledge base memory (8);

rule matching means (24) for comparing the condition part of said candidate rule with the circuit data in said working memory (3), using said element search means (25), said program execution means (6) and circuit recognition means, and for checking the applicability of said candidate rule.

**14.** A logic design system according to claim 13, wherein said inference means (5) further comprises,

element removal means (27) for sequentially removing elements, which are extracted from elements described in their candidate rule, from the data stored in said working memory (3);

element addition means (29) for additionally registering the element, which is extracted from elements described in said candidate rule, into the data stored in said working memory (3);

circuit generating means for generating a subcircuit logically equivalent to a portion of a conclusion part of said candidate rule through element addition means (29) by using said equivalence rule (40); and

rule applying means (28) for updating the data stored in said working memory (3), through additionally registering the circuit described in the conclusion part of said candidate rule or the circuit necessarily generated by said circuit generating means, after confirming said applicability.

### Patentansprüche

**1.** Verfahren zum Transformieren eines ersten Schaltkreises, der durch einen ersten Satz Elemente gebildet ist, in einen logisch äquivalenten, zweiten Schaltkreis, der durch einen zweiten Satz Elemente gebildet ist, das aufweist

Auswahl (51) einer Kandidatenregel von einem Kenntnisgrundspeicher (1), der Transformationsregeln (10, 11, 12) speichert, die allgemeine Regeln (10) und lokale Regeln (11, 12) aufweisen, wobei jede Regel durch eine Formel mit einem Zustandsteil und einem Rückschlußteil ausgedrückt wird;

Erweitern (52) des Zustandsteils der Kandidatenregel durch Ersetzen eines Bereichs des Zustandsteils, der den Zustandsteil einer lokalen Regel anpaßt, durch den Rückschlußteil der lokalen Regel;

Anpassen (53) des erweiterten Zustandsteils der Kandidatenregel an Schaltkreisdaten, die in einem Arbeitsspeicher (3) gespeichert sind;

Entscheiden (54) der Anwendbarkeit der Kandidatenregel;

Entfernen (55) der Elemente des Zustandsteils der Kandidatenregel von den Schaltkreisdaten in dem Arbeitsspeicher (3);

Erweitern (56) des Rückschlußteils der Kandidatenregel durch Ersetzen eines Bereichs des Rückschlußteils, das den Zustandsteil einer lokalen Regel anpaßt, durch den Rückschlußteil der lokalen Regel; und

Anwenden (57) der Kandidatenregel, in der der Zustandsteil und der Rückschlußteil erweitert worden sind, an die Schaltkreisdaten in dem Arbeitsspeicher (3), nachdem die Anwendbarkeit der Kandidatenregel bestätigt ist.

2.  Verfahren nach Anspruch 1, wobei der Schritt eines Anwendens der Kandidatenregel (57) aufweist

Registrieren (72) der Elemente, die von Elementen extrahiert sind, die in dem Rückschlußteil der Kandidatenregel beschrieben sind, in die Schaltkreisdaten, die in dem Arbeitsspeicher (3) gespeichert sind,

Auswählen und Anwenden (73) der lokalen Regel (12), die in dem Kenntnisgrundspeicher (1) gespeichert ist, wie dies durch die Kandidatenregel instruiert ist.

3.  Logisches Designsystem zum Transformieren eines ersten Schaltkreises, der durch einen ersten Satz Elemente gebildet ist, in einen logisch äquivalenten, zweiten Schaltkreis, der durch einen zweiten Satz Elemente gebildet ist, das aufweist

eine Kenntnisgrundspeichereinrichtung (1) zum Speichern von Schaltkreistransformationsregeln (10, 11, 12), die allgemeine Regeln (10) und lokale Regeln (11, 12) aufweisen, wobei jede der Transformationsregeln durch eine Formel mit einem Zustandsteil und einem Rückschlußteil ausgedrückt wird;

eine Eingabeeinrichtung (2) zum Eingeben einer funktionalen Beschreibung und zum Überführen der funktionalen Beschreibung in Schaltkreisdaten;

eine Arbeitsspeichereinrichtung (3) zum Speichern der Schaltkreisdaten;

eine Ausgabeeinrichtung (4) zum Liefern der Schaltkreisdaten von dem Arbeitsspeicher (3);

eine Schlußfolgerungseinrichtung (5) zum Rückschließen auf den zweiten Satz Elemente auf der Basis der Transformationsregeln;

eine Programmausführeinrichtung (6) zum Speichern und Ausführen von Programmen, um die Betriebsweise des Systems zu steuern, die Entscheidungen,

Operationen und Funktionen gemäß den Transformationsregeln (10, 11, 12) umfassen, und

wobei die Schlußfolgerungseinrichtung (5) aufweist:

eine Regelauswahleinrichtung (21) und eine lokale Regelauswahleinrichtung (31) zum Auswählen einer Kandidatenregel aus den Transformationsregeln (10, 11, 12);

eine Regelhalteeinrichtung (22) zum Halten der Kandidatenregel;

eine Regelersetzungseinrichtung (23) zum Erweitern des Zustandsteils und des Rückschlußteils der Kandidatenregel durch Ersetzen eines Bereichs des jeweiligen Teils, der den Zustandsteil einer lokalen Regel anpaßt, durch den Rückschlußteil der lokalen Regel;

eine Elementsucheinrichtung (25) zum Suchen nach Elementen in den Schaltkreisdaten, die in dem Arbeitsspeicher (3) gespeichert sind;

eine Regelanpassungseinrichtung (24) zum Vergleichen des erweiterten Zustandsteils der Kandidatenregel mit den Schaltkreisdaten in dem Arbeitsspeicher (93), und zwar unter Verwendung der Elementsucheinrichtung (25) und der Programmausführeinrichtung (6), und zum Prüfen der Anwendbarkeit der Kandidatenregel;

eine Elementspeichereinrichtung (26) zum Extrahieren von Elementen, die gemäß den Elementen. die in der Kandidatenregel beschrieben sind. entfernt werden sollen, und zum Speichern der extrahierten Elemente;

eine Elementenfernungseinrichtung (27) zum sequentiellen Entfernen der Elemente, die extrahiert sind und in der Elementspeichereinrichtung (26) gespeichert sind, von den Schaltkreisdaten. die in dem Arbeitsspeicher (3) gespeichert sind. nachdem die Anwendbarkeit der Kandidatenregel durch die Regelanpassungseinrichtung (24) eingerichtet ist;

eine Regelanwendungseinrichtung (28) zum Aktualisieren der Daten in dem Arbeitsspeicher (3) durch zusätzliches Registrieren der Elemente, die in dem erweiterten Rückschlußteil durch die Programmausführeinrichtung (6) beschrieben sind, nach Bestätigung der Anwendbarkeit; und

eine Elementhinzufügungseinrichtung (29) zum zusätzlichen Registrieren des Elements, das aus Elementen extrahiert ist, die in dem erweiterten Rückschlußteil der Kandidatenregel beschrieben sind, in die Daten, die in dem Arbeitsspeicher (3) gespeichert sind; und

eine Regelanforderungseinrichtung (30) zum Bewirken, daß die Lokal-Regel-Auswahleinrichtung (31) eine neue Transformationsregel auswählt, die angewandt werden soll, und um sie zu der Regelhalteeinrichtung (22) zu übertragen, wie dies gemäß dem Rückschlußteil der Kandidatenregel notwendig ist, die zuletzt durch die Regelanwendungseinrichtung (28) angewandt war.

4. Logisches Designsystem nach Anspruch 3, wobei die Schlußfolgerungseinrichtung (5) weiterhin aufweist eine Regelersetzungseinrichtung (23) zum Ersetzen eines Teils oder des gesamten einer Kandidatenregel, die in der Regelhalteeinrichtung (22) gehalten wird, durch eine andere Transformationsregel, die den Teil oder das gesamte der Kandidatenregel anpaßt.

5. Logisches Designsystem nach Anspruch 3 oder 4, wobei die Elementspeichereinrichtung (26) Elemente extrahiert, die entfernt werden sollen, gemäß Elementen, die in der Kandidatenregel gespeichert sind, und sie speichert.

6. Verfahren zum Transformieren eines ersten Schaltkreises, der durch einen ersten Satz Elemente aufgebaut ist, in einen logisch äquivalenten Schaltkreis, der durch einen zweiten Satz Elemente aufgebaut ist, das aufweist:

Auswählen (51) einer Kandidatenregel von einem Kenntnisgrundspeicher (1), der Transformationsregeln (13) speichert, wobei jede Regel durch eine Formel mit einem Zustandsteil und einem Rückschlußteil ausgedrückt wird;

Anpassen (53) einer Kandidatenregel an Schaltkreisdaten, die in dem Arbeitsspeicher (3) gespeichert sind;

Prüfen (54) der Anwendbarkeit der Kandidatenregel;

Anwenden (57) der Kandidatenregel bei den Schaltkreisdaten zum Transformieren des Schaltkreises nach Bestätigung der Anwendbarkeit der Kandidatenregeln, wobei dieser Schritt eines Anwendens der Kandidatenregel die Schritte aufweist:

Entscheiden (81, 83, 91, 93), ob jedes Signal der Ausgangs/Eingangssignale eines Elements eine logische Negation eines spezifischen Signals ausdrückt und Extrahieren des Signals, wenn das Element zusätzlich durch Transformieren in die Schaltkreisdaten, die in dem Arbeitsspeicher (3) gespeichert sind, registriert werden sollen;

Aktualisieren (85, 95) der Schaltkreisdaten und Extrahieren des Signals von den Schaltkreisdaten gemäß einer logischen Negationsregel, die von einem Logik-Negations-Kenntnisgrundspeicher (7) ausgewählt ist, Speichern der logischen Negationsregeln (20), die einen logischen Schaltkreis auf einen anderen logischen Schaltkreis beziehen, mit mindestens einer Vielzahl negierter Ausgangs/Eingangssignale, falls die logische Negation dahingehend beurteilt ist, daß sie anwendbar ist, wobei dieses Signal äquivalent zu der logischen Negation des spezifischen Signals ist; und

Erzeugen (87, 96) des Signals durch Hinzufügen eines Inverters, der das spezifische Signal akzeptiert, zu den Schaltkreisdaten, falls die logische Negationsregel dahingehend beurteilt wird, daß sie nicht anwendbar ist.

7. Verfahren nach Anspruch 6, bei dem die Schritte eines Entscheidens, eines Aktualisierens und eines Erzeugens aufweisen:

Entscheiden (83), ob ein Eingangssignal eines Schaltkreiselements ein logisches Negationssignal (~Yi) ist;

Entscheiden (84), ob eine logische Negationsregel in dem Logik-Negations-Kenntnisgrundspeicher (7) gespeichert ist, auf einen anderen Schaltkreis anwendbar ist, unter Abgeben eines Signals (Yi), um ein logisches Negationssignal (~Yi) zu erzeugen;

Aktualisieren (85) der anderen Schaltkreisdaten gemäß der logischen Negationsregel, falls die logische Negationsregel dahingehend beurteilt wird, daß sie in dem Entscheidungsschritt (84) anwendbar ist; und

Hinzufügen (87) eines Inverters, der ein Signal (Yi) eingibt, zu den Schaltkreisdaten und Erzeugen des logischen Negationssignals (~Yi), falls die logische Negationsregel dahingehend beurteilt wird, daß sie nicht in dem Entscheidungsschritt (84) anwendbar ist;

Extrahieren (93) eines logischen Negationssignals (~Yi) von dem Ausgangssignal eines Schaltkreiselements, das in einem Arbeitsspeicher (3) gespeichert ist;

Entscheiden (94), ob eine logische Negationsregel, die in einem Logik-Negations-Kenntnisgrundspeicher (7) gespeichert ist, auf den anderen Schaltkreis anwendbar ist, der in dem Arbeitsspeicher (3) gespeichert ist, wobei ein Signal (Yi) eingegeben wird, um das logische Negationssignal (~Yi) einzugeben;

Aktualisieren (95) der anderen Schaltkreisdaten gemäß der logischen Negationsregel, falls die logische Negationsregel dahingehend beurteilt wird, daß sie in dem Entscheidungsschritt (93) anwendbar ist; und

Hinzufügen (96) eines Inverters, der ein Signal (Yi) eingibt, zu den Schaltkreisdaten, und Erzeugen des logischen Negationssignals (~Yi), falls die logische Negationsregel dahingehend beurteilt wird, daß sie nicht in dem Entscheidungsschritt (94) anwendbar ist.

8. Logisches Designsystem zum Transformieren eines ersten Schaltkreises, der aus einem ersten Satz Elemente aufgebaut ist, in einen logisch äquivalenten zweiten Schaltkreis, der aus einem zweiten Satz Elemente aufgebaut ist, das aufweist

eine Kenntnisgrundspeichereinrichtung (1) zum Speichern von Schaltkreistransformationsregeln (13), wobei jede der Transformationsregeln durch eine Formel mit einem Zustandsteil und einem Rückschlußteil ausgedrückt wird;

eine Eingabeeinrichtung (2) zum Eingeben einer funktionalen Beschreibung und zum Überführen der funktionalen Beschreibung in Schaltkreisdaten;

eine Arbeitsspeichereinrichtung (3) zum Speichern der Schaltkreisdaten;

eine Ausgabeeinrichtung (4) zum Liefern von Schaltkreisdaten von dem Arbeitsspeicher (3);

eine Schlußfolgerungseinrichtung (5) zum Rückschließen auf den zweiten Satz Elemente auf der Basis der Transformationsregeln;

eine Programmausführeinrichtung (6) zum Speichern und Ausführen von Programmen von Verarbeitungsvorgängen, die Enscheidungen, Operationen und Funktionen gemäß den Transformationsregeln (13) umfassen, und

einen Logik-Negations-Kenntnisgrundspeicher (7) zum Speichern logischer Negationsregeln (20), die einen logischen Schaltkreis zu einem anderen logischen Schaltkreis mit mindestens einer Mehrzahl negierter Ein-

EP 0 309 292 B1

gangs/Ausgangssignale in Bezug setzen, und wobei die Schlußfolgerungseinrichtung (5) aufweist

eine Regelauswahleinrichtung (14) zum Auswählen einer Kandidatenregel aus den Transformationsregeln (13);

eine Regelhalteeinrichtung (22) zum Halten der Kandidatenregel;

eine Elementsucheinrichtung (25) zum Suchen nach Elementen in den Schaltkreisdaten, die in dem Arbeitsspeicher (3) gespeichert sind;

eine Regelanpassungseinrichtung (24) zum Vergleichen des Zustandsteils der Kandidatenregel mit den Schaltkreisdaten in dem Arbeitsspeicher (3), und zwar unter Verwendung der Elementsucheinrichtung (25) und der Programmausführeinrichtung (6), und zum Prüfen der Anwendbarkeit der Kandidatenregel;

eine Elementspeichereinrichtung (26) zum Extrahieren von Elementen, die gemäß den Elementen entfernt werden sollen, die in der Kandidatenregel beschrieben sind, und zum Speichern der extrahierten Elemente;

eine Elementenentfernungseinrichtung (27) zum sequentiellen Entfernen der Elemente, die extrahiert und in der Elementspeichereinrichtung (26) gespeichert sind, von den Schaltkreisdaten, die in dem Arbeitsspeicher (3) gespeichert sind, nachdem die Anwendbarkeit der Kandidatenregel durch die Regelanpassungseinrichtung (24) eingerichtet ist;

eine Regelanwendungseinrichtung (28) zum Aktualisieren der Daten in dem Arbeitsspeicher (3) durch zusätzliches Registrieren von Elementen, die in dem Rückschlußteil beschrieben sind, durch die Elementhinzufügungseinrichtung (29) und die Programmausführungseinrichtung (6), nach Bestätigung der Anwendbarkeit; und

eine Elementhinzufügungseinrichtung (29) zum zusätzlichen Registrieren des Elements, das von Elementen extrahiert ist, die in dem Rückschlußteil der Kandidatenregel beschrieben sind, in die Daten, die in dem Arbeitsspeicher (3) gespeichert sind; und

eine ein logisches Negationssignal erzeugende Einrichtung (32) zum Erzeugen des logischen Negationssignals eines spezifischen Signals aus den Daten, die in dem Arbeitsspeicher (3) gespeichert werden sollen, unter Nutzung der logischen Negationsregel (20).

9. Logisches Designsystem nach Anspruch 8, wobei die Elementhinzufügungseinrichtung (29) umfaßt eine Entscheidungseinrichtung zum Entscheiden, ob jedes der Ausgangs- und Eingangssignale eines Elements, das zusätzlich registriert werden soll, eine logische Negation eines spezifischen Signals ausdrückt, und zum Extrahieren des Signals.

10. Logisches Designsystem nach Anspruch 8 oder 9, wobei die Elementhinzufügungseinrichtung (29) umfaßt eine Zuordnungseinrichtung zum Zuordnen eines neuen Signalnamens zu einem unbestimmten Ausgangs- oder Eingangssignal des Elements, das zusätzlich registriert werden soll.

11. Verfahren zum Transformieren eines ersten Schaltkreises, der durch einen ersten Satz Elemente gebildet ist, in einen logisch äquivalenten zweiten Schaltkreis, der aus einem zweiten Satz Elemente gebildet ist, das aufweist

Auswählen (51) einer Kandidatenregel von einem Kenntnisgrundspeicher (1), der Transformationsregeln (13) speichert, wobei jede Regel durch eine Formel mit einem Zustandsteil und einem Rückschlußteil ausgedrückt wird;

Anpassen (53) der Kandidatenregel an Schaltkreisdaten, die in dem Arbeitsspeicher (3) gespeichert sind;

Entscheiden (54) der Anwendbarkeit der Kandidatenregel; und

Anwenden (57) der Kandidatenregeln auf die Schaltkreisdaten zum Transformieren des Schaltkreises, nach Bestätigung der Anwendbarkeit der Kandidatenregel;

24

Erkennen eines Unterschaltkreises der Schaltkreisdaten als ein logisches Schaltkreisäquivalent zu einem Schaltkreis, der in dem Zustandsteil in der Kandidatenregel beschrieben ist, wenn die Anwendbarkeit nicht bestätigt ist, unter Verwendung einer logischen Aquivalenzregel (40), die in einem Logik-Äquivalenz-Kenntnisgrundspeicher (8) gespeichert ist.

12. Verfahren nach Anspruch 11, wobei der Schritt (57) eines Anwendens der Kandidatenregel weiterhin aufweist Erzeugen eines Unterschaltkreises, in den Schaltkreisdaten, der logisch äquivalent zu einem Schaltkreis ist, der in dem Rückschlußteil der Kandidatenregel beschrieben ist, unter Verwendung einer logischen Äquivalenzregel (40), die in dem Logik-Äquivalenz-Kenntnisgrundspeicher (8) gespeichert ist.

13. Logisches Designsystem zum Transformieren eines ersten Schaltkreises, der durch einen ersten Satz Elemente gebildet ist, in einen logisch äquivalenten zweiten Schaltkreis, der durch einen zweiten Satz Elemente gebildet ist, das aufweist

eine Kenntnisgrundspeichereinrichtung (1) zum Speichern von Schaltkreistransformationsregeln (13), wobei jede der Transformationsregeln durch eine Formel mit einem Zustandsteil und einem Rückschlußteil ausgedrückt wird;

eine Eingabeeinrichtung (2) zum Eingeben einer funktionalen Beschreibung und zum Überführen der funktionalen Beschreibung in Schaltkreisdaten,

eine Arbeitsspeichereinrichtung (3) zum Speichern der Schaltkreisdaten;

eine Ausgabeeinrichtung (4) zum Liefern von Schaltkreisdaten von dem Arbeitsspeicher (3);

eine Schlußfolgerungseinrichtung (5) zum Rückschließen auf den zweiten Satz der Elemente auf der Basis der Transformationsregeln;

eine Programmausführeinrichtung (6) zum Speichern und Ausführen von Programmen von Verarbeitungsvorgängen, die Entscheidungen, Operationen und Funktionen umfassen, gemäß den Transformationsregeln (13),

einen Logik-Äquivalenz-Kenntnisgrundspeicher (8) zum Speichern logischer Äquivalenzregeln (40), die ausdrücken, daß ein Schaltkreis logisch zu einem anderen Schaltkreis äquivalent ist; und

wobei die Schlußfolgerungseinrichtung (5) aufweist

eine Regelauswahleinrichtung (14) zum Auswählen einer Kandidatenregel, wobei die Kandidatenregel eine der Transformationsregeln (13) ist;

eine Regelhalteeinrichtung (22) zum Halten der Kandidatenregel;

eine Elementsucheinrichtung (25) zum Suchen nach einem Element in den Schaltkreisdaten, die in dem Arbeitsspeicher (3) gespeichert sind;

eine Schaltkreiserkennungseinrichtung (8, 25) zum Erkennen eines Unterschaltkreises aus Daten als ein logisches Schaltkreisäquivalent zu einem Bereich eines Zustandsteils der Kandidatenregel und einer solchen der Äquivalenzregel (40), die in dem Äquivalenz-Kenntnisgrundspeicher (8) gespeichert ist;

eine Regelanpassungseinrichtung (24) zum Vergleichen des Zustandsteils der Kandidatenregel mit den Schaltkreisdaten in dem Arbeitsspeicher (3), unter Verwendung der Elementsucheinrichtung (25), der Programmausführeinrichtung (6) und der Schaltkreiserkennungseinrichtung, und zum Prüfen der Anwendbarkeit der Kandidatenregel.

14. Logisches Designsystem nach Anspruch 13, wobei die Schlußfolgerungseinrichtung (5) weiterhin aufweist

eine Elemententfernungseinrichtung (27) zum sequentiellen Entfernen von Elementen, die aus Elementen extrahiert sind, die in deren Kandidatenregel beschrieben sind, von den Daten, die in dem Arbeitsspeicher (3) gespeichert sind;

EP 0 309 292 B1

eine Elementhinzufügungseinrichtung (29) zum zusätzlichen Registrieren des Elements, das von den Elementen extrahiert wird, die in der Kandidatenregel beschrieben sind, in die Daten, die in dem Arbeitsspeicher (3) gespeichert sind;

eine Schaltkreiserzeugungseinrichtung zum Erzeugen eines Unterschaltkreises logisch äquivalent zu einem Bereich eines Rückschlußteils der Kandidatenregel durch die Elementhinzufügungseinrichtung (29) unter Verwendung der Äquivalenzregel (40); und

eine Regelanwendungseinrichtung (28) zum Aktualisieren der Daten, die in dem Arbeitsspeicher (3) gespeichert sind, durch zusätzliches Registrieren des Schaltkreises, der in dem Rückschlußteil der Kandidatenregel beschrieben ist, oder des Schaltkreises, der notwendigerweise durch die Schaltkreiserzeugungseinrichtung erzeugt ist, nach Bestätigung der Anwendbarkeit.

**Revendications**

1. Un procédé de transformation d'un premier circuit constitué par un premier ensemble d'éléments en un second circuit, logiquement équivalent, constitué par un second ensemble d'éléments, comprenant

   la sélection (51) d'une règle candidate dans une mémoire de base de connaissances (1) qui enregistre des règles de transformation (10, 11, 12) comprenant des règles générales (10) et des règles locales (11, 12), chaque règle étant exprimée par une formule avec une partie de condition et une partie de conclusion;
   le développement (52) de la partie de condition de la règle candidate par le remplacement d'une portion de la partie de condition qui concorde avec la partie de condition d'une règle locale, par la partie de conclusion de la règle locale;
   la comparaison (53) de la partie de condition développée de la règle candidate avec des données de circuit qui sont enregistrées dans une mémoire de travail (3);
   le jugement (54) de l'applicabilité de la règle candidate;
   l'enlèvement (55) des éléments de la partie de condition de la règle candidate, dans les données de circuit dans la mémoire de travail (3);
   le développement (56) de la partie de conclusion de la règle candidate, par le remplacement d'une portion de la partie de conclusion qui concorde avec la partie de conclusion d'une règle locale, par la partie de conclusion de la règle locale; et
   l'application (57) de la règle locale, dans laquelle la partie de condition et la partie de conclusion ont été développées, aux données de circuit dans la mémoire de travail (3), après la confirmation de l'applicabilité de la règle candidate.

2. Un procédé selon la revendication 1, dans lequel l'étape d'application de la règle candidate (57) comprend

   l'enregistrement (72) des éléments qui sont extraits d'éléments décrits dans la partie de conclusion de la règle candidate, dans les données de circuit qui sont enregistrées dans la mémoire de travail (3);
   la sélection et l'application (73) de la règle locale (12) enregistrée dans la mémoire de base de connaissances (1), conformément à ce qu'indique la règle candidate.

3. Un système de conception logique pour transformer un premier circuit constitué par un premier ensemble d'éléments en un second circuit logiquement équivalent, constitué par un second ensemble d'éléments, comprenant

   des moyens de mémoire de base de connaissances (1) pour enregistrer des règles de transformation de circuit (10, 11, 12), comprenant des règles générales (10) et des règles locales (11, 12), chacune des règles de transformation étant exprimée par une formule avec une partie de condition et une partie de conclusion;
   des moyens d'entrée (2) pour introduire une description fonctionnelle et pour traduire cette description fonctionnelle en données de circuit;
   des moyens de mémoire de travail (3) pour enregistrer les données de circuit;
   des moyens de sortie (4) pour fournir des données de circuit à partir de la mémoire de travail (3);
   des moyens d'inférence (5) pour inférer le second ensemble d'éléments sur la base des règles de transformation;
   des moyens d'exécution de programme (6) pour enregistrer et exécuter des programmes pour commander des opérations du système, comprenant des jugements, des opérations et des fonctions en conformité avec les règles de transformation (10, 11, 12),
et les moyens d'inférence (5) comprenant :
des moyens de sélection de règle (21) et des moyens de sélection de règle locale (31) pour sélectionner une règle candidate parmi les règles de transformation (10, 11, 12);
des moyens de conservation de règle (22) pour conserver la règle candidate;
des moyens de remplacement de règle (23) pour développer la partie de condition et la partie de conclusion de la règle candidate, en remplaçant une portion de la partie respective qui concorde avec la partie de condition d'une règle locale, par la partie de conclusion de la règle locale;
des moyens de recherche d'éléments (25) pour rechercher des éléments dans les données de circuit qui sont enregistrées dans la mémoire de travail (3);
des moyens de comparaison de règle (24) pour comparer la partie de condition développée de la règle candidate avec les données de circuit dans la mémoire de travail (3), en utilisant les moyens de recherche d'élément (25) et les moyens d'exécution de programme (6), et pour contrôler l'applicabilité de la règle candidate;
des moyens d'enregistrement d'éléments (26) pour extraire des éléments à enlever, conformément à des éléments qui sont décrits dans la règle candidate, et pour enregistrer les éléments extraits;
des moyens d'enlèvement d'éléments (27) pour enlever séquentiellement des données de circuit qui sont enregistrées dans la mémoire de travail (3), les éléments qui sont extraits et enregistrés dans les moyens d'enregistrement d'éléments (26), après que l'applicabilité de la règle candidate a été établie par les moyens de comparaison de règle (24);
des moyens d'application de règle (28) pour actualiser les données dans la mémoire de travail (3), en enregistrant en supplément, à l'aide des moyens d'exécution de programme (6), les éléments qui sont décrits dans la partie de conclusion développée, après confirmation de l'applicabilité; et
des moyens d'ajout d'éléments (29) pour enregistrer en supplément dans les données qui sont enregistrées dans la mémoire de travail (3) l'élément qui est extrait d'éléments décrits dans la partie de conclusion développée de la règle candidate; et
des moyens de demande de règle (30) pour faire en sorte que les moyens de sélection de règle locale (31) sélectionnent une nouvelle règle de transformation à appliquer, et transmettent celle-ci aux moyens de conservation de règle (22), de la manière nécessaire conformément à la partie de conclusion de la règle candidate qui a été appliquée en dernier par les moyens d'application de règle (28).

4. Un système de conception logique selon la revendication 3, dans lequel les moyens d'inférence (5) comprennent en outre
des moyens de remplacement de règle (23) pour remplacer une partie ou la totalité d'une règle candidate qui est conservée dans les moyens de conservation de règle (22), par une autre règle de transformation qui concorde avec cette partie ou la totalité de la règle candidate précitée.

5. Un système de conception logique selon la revendication 3 ou 4, dans lequel les moyens d'enregistrement d'éléments (26) extraient des éléments à enlever, conformément à des éléments qui sont décrits dans la règle candidate, et ils les enregistrent.

6. Un procédé de transformation d'un premier circuit constitué par un premier ensemble d'éléments en un circuit logiquement équivalent, constitué par un second ensemble d'éléments, comprenant

la sélection (51) d'une règle candidate dans une mémoire de base de connaissances (1) qui enregistre des règles de transformation (13), chaque règle étant exprimée par une formule avec une partie de condition et une partie de conclusion;
la comparaison (53) d'une règle candidate avec des données de circuit qui sont enregistrées dans une mémoire de travail (3);
le contrôle (54) de l'applicabilité de la règle candidate;
l'application (57) de la règle candidate aux données de circuit, pour transformer le circuit, après confirmation de l'applicabilité de la règle candidate, cette étape d'application de la règle candidate comprenant les étapes suivantes :
on juge (81, 83, 91, 93) si chaque signal parmi des signaux de sortie/entrée d'un élément exprime une négation logique d'un signal spécifique, et on extrait ce signal lorsque l'élément est en outre enregistré par transformation sous la forme des données de circuit qui sont enregistrées dans la mémoire de travail (3);
on actualise (85, 95) les données de circuit et on extrait le signal précité des données de circuit, conformément à une règle de négation logique qui est sélectionnée dans une mémoire de base de connaissances de négation logique (7), enregistrant des règles de négation logique (20) qui lient un circuit logique à un autre circuit logique ayant au moins un signal parmi plusieurs signaux de sortie/entrée faisant l'objet d'une négation, si la négation logique est jugée applicable, ce signal étant équivalent à la négation logique du signal spécifique; et

on génère (87, 96) le signal précité en ajoutant aux données de circuit un inverseur qui accepte le signal spécifique, si la règle de négation logique est jugée inapplicable.

**7.** Un procédé selon la revendication 6, dans lequel les étapes de jugement, d'actualisation et de génération comprennent les étapes suivantes :

on juge (83) si un signal d'entrée d'un élément de circuit est un signal de négation logique ($\sim$Yi);

on juge (84) si une règle de négation logique, qui est enregistrée dans une mémoire de base de connaissances de négation logique (7), est applicable à un autre circuit donnant un signal (Yi) pour générer le signal de négation logique ($\sim$Yi);

on actualise (85) les autres données de circuit précitées, conformément à la règle de négation logique, si on juge, à l'étape de jugement (84) que la règle de négation logique est applicable; et

on ajoute (87) aux données de circuit un inverseur qui reçoit le signal (Yi) en entrée et qui génère le signal de négation logique ($\sim$Yi), si on juge à l'étape de jugement (84) que la règle de négation logique est inapplicable;

on extrait (93) un signal de négation logique ($\sim$Yi) à partir du signal de sortie d'un élément de circuit qui est enregistré dans une mémoire de travail (3);

on juge (94) si une règle de négation logique, qui est enregistrée dans une mémoire de base de connaissances de négation logique (7), est applicable à l'autre circuit enregistré dans la mémoire de travail (3), recevant en entrée un signal (Yi), pour recevoir en entrée le signal de négation logique ($\sim$Yi);

on actualise (95) les autres données de circuit précitées, conformément à la règle de négation logique, si on juge à l'étape de jugement (93) que la règle de négation logique est applicable; et

on ajoute (96) aux données de circuit, un inverseur qui reçoit en entrée un signal (Yi), et qui génère le signal de négation logique ($\sim$Yi), si on juge à l'étape de jugement (94) que la règle de négation logique st inapplicable.

**8.** Un système de conception logique pour transformer un premier circuit constitué par un premier ensemble d'éléments en un second circuit logiquement équivalent, constitué par un second ensemble d'éléments, comprenant

des moyens de mémoire de base de connaissances (1) pour enregistrer des règles de transformation de circuit (13), chacune des règles de transformation étant exprimée par une formule avec une partie de condition et une partie de conclusion;

des moyens d'entrée (2) pour introduire une description fonctionnelle et pour traduire cette description fonctionnelle en données de circuit;

des moyens de mémoire de travail (3) pour enregistrer les données de circuit;

des moyens de sortie (4) pour fournir des données de circuit à partir de la mémoire de travail (3);

des moyens d'inférence (5) pour inférer le second ensemble d'éléments sur la base des règles de transformation;

des moyens d'exécution de programme (6) pour enregistrer et exécuter des programmes d'opérations de traitement, comprenant des jugements, des opérations et des fonctions, conformément aux règles de transformation (13), et

une mémoire de base de connaissances de négation logique (7) pour enregistrer des règles de négation logique (20) qui lient un circuit logique à un autre circuit logique, avec au moins un signal parmi plusieurs signaux de sortie/entrée faisant l'objet d'une négation,

et les moyens d'inférence (5) comprenant :

des moyens de sélection de règle (14) pour sélectionner une règle candidate parmi les règles de transformation (13);

des moyens de conservation de règle (22) pour conserver la règle candidate;

des moyens de recherche d'éléments (25) pour rechercher des éléments dans les données de circuit qui sont enregistrées dans la mémoire de travail (3);

des moyens de comparaison de règle (24) pour comparer la partie de condition de la règle candidate avec les données de circuit dans la mémoire de travail (3), en utilisant les moyens de recherche d'éléments (25) et les moyens d'exécution de programme (6), et pour contrôler l'applicabilité de la règle candidate;

des moyens d'enregistrement d'éléments (26) pour extraire des éléments à enlever, conformément à des éléments qui sont décrits dans la règle candidate, et pour enregistrer ces éléments extraits;

des moyens d'enlèvement d'éléments (27) pour enlever séquentiellement des données de circuit qui sont enregistrées dans la mémoire de travail (3), les éléments qui sont extraits et enregistrés dans les moyens d'enregistrement d'éléments (26), après que l'applicabilité de la règle candidate a été établie par les moyens de comparaison de règle (24);

des moyens d'application de règle (28) pour actualiser les données dans la mémoire de travail (3), par l'enregistrement en supplément d'éléments qui sont décrits dans la partie de conclusion, à l'aide de moyens d'ajout d'éléments (29) et des moyens d'exécution de programme (6), après la confirmation de l'applicabilité; et

des moyens d'ajout d'éléments (29) pour enregistrer en supplément, dans les données qui sont enregistrées dans la mémoire de travail (3), l'élément qui est extrait d'éléments qui sont décrits dans la partie de conclusion de la règle candidate; et

des moyens de génération de signal de négation logique (32) pour générer le signal de négation logique d'un signal spécifique, à partir des données qui sont enregistrées dans la mémoire de travail (3), en utilisant les règles de négation logique (20).

9. Un système de conception logique selon la revendication 8, dans lequel les moyens d'ajout d'éléments (29) comprennent

des moyens de jugement pour juger si chacun des signaux de sortie ou d'entrée d'un élément devant être enregistré en supplément exprime une négation logique du signal spécifique, et pour extraire ce signal.

10. Un système de conception logique selon la revendication 8 ou 9, dans lequel les moyens d'ajout d'éléments (29) comprennent

des moyens d'affectation pour affecter un nouveau non de signal à des signaux de sortie indéterminés de l'élément à enregistrer en supplément.

11. Un procédé de transformation d'un premier circuit constitué par un premier ensemble d'éléments en un second circuit logiquement équivalent, constitué par un second ensemble d'éléments, comprenant

la sélection (51) d'une règle candidate dans une mémoire de base de connaissances (1) dans laquelle sont enregistrées des règles de transformation (13), chaque règle étant exprimée par une formule avec une partie de condition et une partie de conclusion;

la comparaison (53) de la règle candidate avec des données de circuit qui sont enregistrées dans une mémoire de travail (3);

le jugement (54) de l'applicabilité de la règle candidate;

l'application (57) de la règle candidate aux données de circuit pour transformer le circuit, après confirmation de l'applicabilité de la règle candidate; et

la reconnaissance d'un sous-circuit des données de circuit comme étant un circuit qui est l'équivalent logique d'un circuit décrit dans la partie de condition de la règle candidate, lorsque l'applicabilité n'est pas confirmée, en utilisant une règle d'équivalence logique (40) qui est enregistrée dans une mémoire de base de connaissances d'équivalence logique (8).

12. Un procédé selon la revendication 11, dans lequel l'étape (57) d'application de la règle candidate comprend en outre la génération d'un sous-circuit, dans les données de circuit, qui est l'équivalent logique d'un circuit décrit dans la partie de conclusion de la règle candidate, par l'utilisation d'une règle d'équivalence logique (40) qui est enregistrée dans la mémoire de base de connaissances d'équivalence logique (8).

13. Un système de conception logique pour transformer un premier circuit constitué par un premier ensemble d'éléments en un second circuit logiquement équivalent, constitué par un second ensemble d'éléments, comprenant

des moyens de mémoire de base de connaissances (1) pour enregistrer des règles de transformation de circuit (13), chacune des règles de transformation étant exprimée par une formule avec une partie de condition et une partie de conclusion;

des moyens d'entrée (2) pour introduire une description fonctionnelle et pour traduire cette description fonctionnelle en données de circuit;

des moyens de mémoire de travail (3) pour enregistrer les données de circuit;

des moyens de sortie (4) pour fournir les données de circuit à partir de la mémoire de travail (3);

des moyens d'inférence (5) pour inférer le second ensemble d'éléments sur la base des règles de transformation;

des moyens d'exécution de programme (6) pour enregistrer et exécuter des programmes d'opérations de traitement, comprenant des jugements, des opérations et des fonctions conformes aux règles de transformation (13),

une mémoire de base de connaissances d'équivalence logique (8) pour enregistrer des règles d'équivalence logique (40) qui expriment le fait qu'un circuit est l'équivalent logique d'un autre circuit; et
des moyens d'inférence (5) comprenant :
des moyens de sélection de règle (14) pour sélectionner une règle candidate, la règle candidate étant l'une des règles de transformation (13);
des moyens de conservation de règle (22) pour conserver la règle candidate;
des moyens de recherche d'éléments (25) pour rechercher un élément dans des données de circuit qui sont enregistrées dans la mémoire de travail (3);
des moyens de reconnaissance de circuit (8, 25) pour reconnaître un sous-circuit de données comme étant un circuit qui est l'équivalent logique d'une portion de la partie de condition de la règle candidate et de l'une des règles d'équivalence (40) qui sont enregistrées dans la mémoire de base de connaissances d'équivalence logique (8); et
des moyens de comparaison de règle (24) pour comparer la partie de condition de la règle candidate avec les données de circuit dans la mémoire de travail (3), en utilisant les moyens de recherche d'éléments (25), les moyens d'exécution de programme (6) et les moyens de reconnaissances de circuit, et pour contrôler l'applicabilité de cette règle candidate.

14. Un système de conception logique selon la revendication 13, dans lequel les moyens d'inférence (5) comprennent en outre,

des moyens d'enlèvement d'éléments (27) pour enlever séquentiellement dans les données enregistrées dans la mémoire de travail (3), des éléments qui sont extraits d'éléments décrits dans leur règle candidate;
des moyens d'ajout d'éléments (29) pour enregistrer en supplément, dans les données enregistrées dans la mémoire de travail (3), l'élément qui est extrait d'éléments décrits dans la règle candidate;
des moyens de génération de circuit pour générer un sous-circuit qui est l'équivalent logique d'une portion d'une partie de conclusion de la règle candidate, à l'aide des moyens d'ajout d'éléments (29), par l'utilisation de la règle d'équivalence (40); et
des moyens d'application de règle (28) pour actualiser les données qui sont enregistrées dans la mémoire de travail (3), en enregistrant en supplément le circuit qui est décrit dans la partie de conclusion de la règle candidate, ou le circuit qui est nécessairement généré par les moyens de génération de circuit, après confirmation de l'applicabilité.

FIG. I

Knowledge Base Memory 1

General Rule 10
Local Rule 12
Local Rule 11

Program Execution Unit 6

General Rule Selection Means 21
Rule Replacing Means 23
Local Rule Selection Means 31

Rule Matching Means 24
Rule Holding Means 22
Rule Applying Means 28
Rule Requisition Means 30

Element Search Means 25
Element Storage Means 26
Element Removal Means 27
Element Addition Means 29

Inference Unit 5

Working Memory 3

Input 2

Output 4

FIG . 2

$A$ , $B$ , $C_1$ , $D_1$ ⟶ $E_1$ , $G$ .

$A$ , $B$ , $C_2$ , $D_2$ ⟶ $E_2$ , $F_2$ , $G$

$A$ , $B$ , $C_3$ ⟶ $E_3$ , $F_3$ , $G$

⇓ Hierarchical Structuring

[Main Rule]

$A$ , $B$ ⟶ ✳ , $G$

[Subordinate Rule]

✳ , $C_1$ , $D_1$ ⟶ $E_1$

✳ , $C_2$ , $D_2$ ⟶ $E_2$ , $F_2$

✳ , $C_3$ ⟶ $E_3$ , $F_3$

FIG. 3 (a)

Main Rule

$$\left(\begin{array}{l}\text{NOR is connected to NOR}\\\text{output of which fan out}\\\text{is I}\end{array}\right) \qquad \left(\begin{array}{l}\text{AND - NOR compound}\\\text{gate is used}\end{array}\right)$$

FIG. 3 (b)

Subordinate Rule

$$\left(\begin{array}{l}\text{When using AND - NOR}\\\text{compound gate, 2 - input}\\\text{and 3- input NOR are}\\\text{connected to the inputs of}\\\text{2 - input NOR}\end{array}\right) \qquad \left(\begin{array}{l}\text{Inverter connected to}\\\text{inputs of AND - NOR}\\\text{compound gate antdoo}\end{array}\right)$$

FIG. 3 (c)

Expanding Rule

$$\left(\begin{array}{l}\text{Logic inversion of}\\\text{plural signals}\end{array}\right) \qquad \left(\begin{array}{l}\text{Inverter is attached}\\\text{to each signal}\end{array}\right)$$

# FIG. 4 (a)

Example of data expressing
circuit of Fig. 4(b)

42 Attribute Code

41 Identity Name            43 Attribute Value

gate O1 ::: a - kind - of : : nor ;    ;

             input        : : [sig1 , sig2 , sig3] ;

             output       : :   sig4  ;

             fanout       : :   3    .

# FIG. 4 (b)

Circuit composed of
3 - input nor of 3 fan - outs

gate O1

sig 1
sig2
sig 3

sig 4

# FIG. 5

Start

51 Rule selection Processing

52 Expansion Processing of Rule Condition Part

53 Matching Processing of Rule Condition Part

54 Judgement of Establishment of Condition Part

Established — Not Established

55 Removal of Element From Working Memory Part

56 Expansion Processing of Rule Conclusion Part

57 Application Processing of Rule Conclusion Part

58 Presence or Absence of Next Rule

Present — Absent

End

FIG. 6

Start

60

L ← 1

61 judgement of L-th Term
Processing

Element

62

Checking and
Collation with Data
In Working
Memory

66

Commanding To
Program Execution
Part, and Execution
of Processing

69

L ← L + 1

Judgement of Establishment 63
Established                    Not-Established

67
Judgement
Establishment

64
Judgement of
Removal Element

Nō                    Established

YES

65

Storing as
Removal Element

Not- Established

68 Judgement of Final Term

Nō

YES

Condition Established          Condition not Established

FIG. 7

```
                        ┌──────────┐
                        │  Start   │
                        └─────┬────┘
                              │
                          70 ┌┴─────────┐
                             │  M ← 1   │
                             └────┬─────┘
                                  │
                  71 Judgement of M-th Term
                                  │
           Element  ◇ Processing
          ┌──────────┴──────────┬──────────────┐
      72  │                 73  │          74  │
  ┌───────────────┐  ┌───────────────┐  ┌──────────────────┐
  │ Addition  of  │  │ Subordinate   │  │ Commanding To    │
  │ Element in    │  │ Rule          │  │ Program Execution│
  │ Data in       │  │ Application   │  │ Part, and        │
  │ Working       │  │ Processing    │  │ Execution of     │
  │ Memory        │  │               │  │ Processing       │
  └───────────────┘  └───────────────┘  └──────────────────┘
   76 ┌──────────┐
      │ M ← M+1  │
      └──────────┘
                          75 Judgement of Final Term
                                  ◇
                                  │
                        ┌─────────┴┐
                        │   End    │
                        └──────────┘
```

## FIG. 8 (a)

### Description Example of Main Rule

```
(Gatel ::: a_kind_of :: nor ;
        input     :: [YI,Y2IL2];
        output    :: Z ;
        fanout    :: N),
length(L2,M2),M2=<2,
(Gate2 ::: a_kind_of :: nor ;
        input     :: [XILI] ;
        output    :: YI ;
        fanout    :: I).
length(LI,MI), MI=<3,
MI+M2=<2
   ==> @ (Gate ::: a_kind_of :: gnd_nor ;
              input(a) ::  [XILI] ;
              input    :: [Y2IL2];
              output   :: Z ;
              fanout   :: N).
```

## FIG. 8 (b)

### Description Example of Subordinate Rule

```
(Gate ::: a_kind_of :: gnd_nor ;
        input(a) :: [XII,XI2] ;
        input    :: [Y2] ;
        output   :: Z ;
        fanout   :: N) ,
(GateO::: a_kind_of :: nor ;
        output   :: Y2 ;
        input    :: [X2I,X22,X23];
        fanout   :: I )
   @=) # (Gatel ::: a_kind_of :: inverter ;
                input  :: [XII,XI2] ;
                output :: [NXII,NXI2] ;
                fanout :: I ),
        # (Gate2 ::: a_kind_of :: inverter ;
                input  :: [X2I,X22,X23] ;
                output :: [NX2I,NX22,NX23] ;
                fanout :: I ),
        (Gate3 ::: a_kind_of :: antdoo ;
                input(a) :: [NXII,NXI2] ;
                input(b) :: [NX2I,NX22,NX23] ;
                output   :: Z ;
                fanout   :: N ),
```

FIG. 9

```
(Gate ::: a_kind_of :: inverter ;
         input      :: (XIL I);
         output     :: (YIL 2);
         fanout     :: N)
 #=> (Gate ::: a_kind_of :: inverter ;
             input      :: X ;
             output     :: Y ;
             fanout     :: N).
    # (Gate ::: a_kind_of :: inverter ;
             input      :: LI ;
             output     :: L2 ;
             fanout     :: N).


(Gate ::: a_kind_of :: inverter ;
         input      :: () ;
         output     :: () ;
         fanout     :: N)
 # => true.
```

FIG. 10

FIG. 11 (a)

FIG. 11 (b)

FIG. 11 (c)

FIG. 12

```
                          ┌─────────┐
                          │  Start  │
                          └─────────┘
                               │
     ┌─────────────────────────┤
     │                    ┌─────────────────┐ 51
     │                    │ Rule Selection  │
     │                    │ Processing      │
     │                    └─────────────────┘
     │                         │
     │                         :
     │   ┌─────────────────────┤
     │   │              ┌──────────────────┐ 53
     │   │              │ Matching Processing│
     │   │              │ of Rule Condition │
     │   │              │ Part              │
     │   │              └──────────────────┘
     │   │                      │
     │   │   Established    ╱◇╲    Not Established
     │   │      ┌──────────◇    ◇──────────┐
     │   │      │          ╲◇╱              54 Judgement of
     │   │  55  │                              Establishment of
     │   │  ┌───────────────┐                  Condition Part
     │   │  │ Removal of    │                      │         Absence
     │   │  │ Element From  │                   ╱◇╲ ──────────┐
     │   │  │ Working Memory│          ┌───────◇   ◇          │
     │   │  └───────────────┘          │       ╲◇╱            │
     │   │      │           58 Presence or  Presence          │
     │   │      │              Absence of                     │
     │   │      │              Next Rule                      │
     │   │  57  │                                             │
     │   │  ┌───────────────┐                                 │
     │   │  │ Application   │                                 │
     │   │  │ Processing    │                                 │
     │   │  │ of Rule       │                                 │
     │   │  │ Conclusion    │                                 │
     │   │  │ Part          │                                 │
     │   │  └───────────────┘                            ┌─────────┐
     │   └──────────┘                                    │  End    │
     └──────────────────────────────────────────────────┘─────────┘
```

FIG. 13

```
        ┌──────────────┐
        │    Start      │
        └──────┬───────┘
               │              80
        ┌──────┴───────┐
        │ Logic Negation │
        │ Signal Generation │
        │ of All Registered │
        │ Elements.     │
        └──────┬───────┘
               │              100
        ┌──────┴───────┐
        │              │
        │   Addition    │
        │              │
        │  of Elements  │
        │              │
        └──────┬───────┘
               │
        ┌──────┴───────┐
        │     End       │
        └──────────────┘
```

EP 0 309 292 B1

FIG. 14

44

FIG. 15

```
( Gate 0 ::: a_Kind_of :: or ;
           input        :: [XI ,X2] ;
           output       ::   Z )
= = > (Gate I ::: a_Kind_of :: inverter;
                  input        :: XI ;
                  output       :: YI ) ,
      (Gate 2 ::: a_Kind_of :: inverter;
                  input        :: X2 ;
                  output       :: Y2 ) ,
      (Gate 3 ::: a_Kind_of :: nand ;
                  input        ::[YI , Y2] ;
                  output       :: Z ).
```

FIG. 16

```
(Gate  ::: a_kind_of  :: and ;
            input        :: [X:L] ;
            output       :: Z )
   =~ (Gate ::: a_kind_of :: nand ;
                 input       :: [X:L] ;
                 output      :: NZ).


(Gate ::: a_kind_of :: or ;
           input        :: [X:L] ;
           output       :: Z )
   =~ (Gate ::: a_kind_of  :: nor ;
                 input       :: [X:L] ;
                 output      :: NZ).
```

•
•
•

FIG. 17

```
(Gate O  ::: a_kind_of :: or ;
            input      :: [X1,X2];
            output     :: Z ).
   ==>  (Gate1 ::: a_kind_of :: nand ;
                  input       :: [~X1, ~X2];
                  output      :: Z).
```

46

FIG. 18

Logic Equivalence Rule — 40

Logic Equivalence Knowledge Base Memory — 8

EP 0 309 292 B1

FIG. 19 (a)

FIG. 19 (b)

FIG. 19 (c)

FIG. 19 (d)

"1"

# F I G. 20

$$\begin{pmatrix} \text{To Inputs of 2-input NOR element,} \\ \text{2-input AND element and 3-input} \\ \text{AND element of which fan-out is.} \\ \text{both 1 are connected.} \end{pmatrix}$$

$$\begin{pmatrix} \text{Transformed to AND-NOR} \\ \text{complex gate antdoo.} \end{pmatrix}$$

EP 0 309 292 B1

FIG. 21 (a)

FIG. 21 (b)

FIG. 21 (c)

"1"

EP 0 309 292 B1

FIG. 23

FIG. 24 (a)

FIG. 24 (b)

EP 0 309 292 B1

53

EP 0 309 292 B1

FIG. 25